(19) Europäisches Patentamt
European Patent Office
Office européen des brevets

(11) **EP 2 355 166 A1**

(12) **EUROPEAN PATENT APPLICATION**
published in accordance with Art. 153(4) EPC

(43) Date of publication:
**10.08.2011 Bulletin 2011/32**

(51) Int Cl.:
*H01L 31/042* (2006.01) *H01L 33/00* (2010.01)

(21) Application number: **09827366.7**

(22) Date of filing: **19.11.2009**

(86) International application number:
**PCT/JP2009/006237**

(87) International publication number:
**WO 2010/058585 (27.05.2010 Gazette 2010/21)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **19.11.2008 JP 2008295374**
**07.07.2009 JP 2009160853**

(71) Applicant: **Toppan Printing Co., Ltd.**
**Tokyo 110-8560 (JP)**

(72) Inventors:
• **MURILLO-MORA, Luis Manuel**
**Tokyo 110-8560 (JP)**

• **HONMA, Hideaki**
**Tokyo 110-8560 (JP)**
• **MORONAGA, Kohei**
**Tokyo 110-8560 (JP)**
• **TAKAHASHI, Susumu**
**Tokyo 110-8560 (JP)**

(74) Representative: **Gwilt, Julia Louise et al**
**Marks & Clerk LLP**
**62-68 Hills Road**
**Cambridge**
**CB2 1LA (GB)**

(54) **LIGHT REUSE SHEET, SOLAR BATTERY MODULE, AND LIGHT SOURCE MODULE**

(57) A light reuse sheet includes a reflective surface (100) having an uneven configuration, the reflective surface (100) in order to reflect light in a specific direction so as to cause light to be incident to a solar battery cell (1), the light being incident to a solar battery module (200), or in order to exit light in a specific direction by reflecting the light, the light being emitted from a light emitting element (50) of a light source module (300). The reflective surface (100) satisfies the following formula where a length in a horizontal direction of a solar battery cell (1) or a light emitting element (50) is represented by Lx; a length in a vertical direction of a solar battery cell (1) or a light emitting element (50) is represented by Ly; an angle formed between a direction of an uneven configuration of the reflective surface (100) and an edge in a horizontal direction of the solar battery cell (1) or the light emitting element (50) is represented by φ; and maximum width of light which passes between adjacent solar battery cells (1) and which is reflected by a light reuse sheet and is incident to a light receiving face of a solar battery cell (1) or maximum width of light which is not emitted from a light emitting element (50) in a specific direction and which exits in a specific direction by reflecting the light at a light reuse sheet is represented by A.

(Formula 1)

$$\frac{df}{d\phi} = 0 = Ly \cdot \cos\phi - Lx \cdot \sin\phi - A(\cos^2\phi - \sin^2\phi)$$

EP 2 355 166 A1

# FIG. 1

**Description**

BACKGROUND OF THE INVENTION

Field of the Invention

The present invention relates to a light reuse sheet having an uneven structure formed on at least one surface thereof, deflecting light in a specific direction using the diffraction, scattering, refraction, or reflection action of light so that light that have been conventionally lost can be reused, relates to a solar battery module, and relates to a light source module in which the light reuse sheet is used.

Furthermore, the present invention relates to a sheet reusing light of a light emitting element such as an LED or an EL element in which this light reuse sheet is used, and to a light emitting element using the sheet.

Priority is claimed on Japanese Patent Application No. 2008-295374, filed November 19, 2008, and Japanese Patent Application No. 2009-160853, filed July 7, 2009, the contents of which are incorporated herein by reference.

Background Art

In recent years, as solar battery modules have been in widespread use, solar battery modules are being used in a variety of fields.

For example, solar battery modules are used in comparatively small instruments that are mounted in small-sized electronic instruments such as calculators and the like, and solar battery modules are also mounted in homes for use by the household. Moreover, solar battery power generating systems having a large surface area are used in large-scale power generating plants, and solar battery modules are even used as power sources for artificial satellites (see, for example, Japanese Unexamined Patent Application, First Publication No. 2001-295437).

In these solar batteries, the quantity of power generated increases principally in proportion to the surface area which are irradiated with light.

Accordingly, in order to improve power generation efficiency, in addition to improving manufacturing technologies, such as sealing technology and film-forming technology, it is an important issue to increase the aperture ratio (the proportion of the area capable of generating power relative to the total area) of the solar battery module.

Moreover, generally, the types of materials used for a solar battery are classified into crystalline silicon-based types, amorphous silicon-based types, and organic compound-based types. Moreover, crystalline silicon-based solar batteries which are circulating in considerable quantities in the current marketplace are further classified into single-crystalline silicon types, polycrystalline silicon types, and amorphous silicon types.

Single-crystalline silicon type and polycrystalline type solar batteries have a better quality substrate compared to other solar batteries, and therefore have the virtue that increasing the power generation efficiency is comparatively easy.

However, single-crystalline type and polycrystalline type solar batteries have the drawback that a high proportion of the costs is taken up by materials (i.e., the cost of silicon is high).

Moreover, the cost of adhering solar battery cells onto a module is added to the manufacturing costs.

Therefore, technology has been proposed that uses thin-film silicon solar battery cells in which there is a small quantity of silicon, which is a constituent element of a solar battery cell, and that can be formed into a film using technology such as CVD

(Chemical Vapor Deposition).

However, in the above system, because infrared light, in particular, is able to easily pass through a thin-film silicon solar battery cell, a light absorption factor is low.

Therefore, in order to improve the light utilization efficiency, a structure has been proposed that improves the light utilization efficiency by scattering incidence light and utilizing the optical path length of the light that is transmitted through the thin-film silicon solar battery cell.

Generally, two types of structure are known in amorphous silicon solar batteries.

As a first structure, a structure is known in which a transparent conductive film such as $SnO_2$ or ITO (indium tin oxide) is formed on a transparent substrate such as glass, and a p-layer, an i-layer, and an n-layer of an amorphous semiconductor (Si) are stacked in this sequence on the transparent conductive film.

Moreover, in this structure, a transparent conductive film and a back-side electrode are formed in this sequence on top of the layered body formed by the p-layer, the i-layer, and the n-layer.

As a second structure, a structure is known in which a photoelectric conversion active layer is formed on a metal substrate electrode by stacking an n-layer, an i-layer, and a p-layer of an amorphous semiconductor (Si) in this sequence thereon, and then stacking a transparent conductive film and a back-side electrode on top of the photoelectric conversion active layer.

The first structure, in particular, has the following advantage.

Specifically, because the amorphous semiconductor is formed in the sequence of p-i-n layers, a transparent-insulative substrate can be made to function as the base substrate of the solar battery, and can also be made to function as a cover glass covering the surface of the solar battery.

Moreover, because transparent conductive films formed from $SnO_2$ having resistance to plasma have been developed, a photoelectric conversion active layer made of an amorphous semiconductor can be formed on a transparent conductive film by a plasma CVD method.

Because it has the aforementioned advantages, the above-described first structure is currently widely used.

Additionally, as the method used to form a photoelectric conversion active layer made of an amorphous semiconductor, either a plasma CVD method in which glow discharge decomposition is performed on a raw material gas, or a vapor-phase epitaxial method using a photo CVD method can be used.

By employing these methods, a thin-film having a large surface area can be formed.

Moreover, an amorphous Si solar battery can be formed at a comparatively low temperature of 100°C to 200°C.

Because of this, substrates formed from a variety of substances can be used as the substrate that is used to form an amorphous Si solar battery.

Normally, the most commonly used substrates are glass substrates and stainless steel substrates.

Moreover, in an amorphous Si solar battery, the film thickness of the silicon light absorption layer which provides the maximum conversion efficiency of light into electricity is approximately 500 nm.

Because of this, in order to improve the conversion efficiency, it is essential to increase the light absorption quantity within the film thickness of the light absorption layer.

In order to improve the conversion efficiency, conventionally, the optical path length of light within the light absorption layer increases by forming a transparent conductive film having irregularity in the surface thereof on a glass substrate, or by forming a metal film having irregularity in the surface thereof on a stainless steel substrates.

In a solar battery which is manufactured using a method such as this, the optical path length within the light absorption layer increases and the light utilization efficiency is improved markedly compared with a structure in which an amorphous Si solar battery is formed on a flat substrate that does not have irregularity on the surface of the light absorption layer.

On the other hand, as a common method for forming irregularity on the surface of a glass substrate, a method for forming an $SnO_2$ film which serves as a transparent electrode by use of an atmospheric pressure CVD process.

Moreover, as a method for forming irregularity on the surface of a metal substrate such as stainless steel or the like, a method is used in which, when Ag is being formed by use of vapor deposition or sputtering, the formation conditions are adjusted and heat processing is then performed after the Ag has been formed.

The above-described thin-film solar batteries have a structure in which a transparent conductive film, a hydrogenated amorphous silicon carbide (a-SiC:H) p layer, a hydrogenated amorphous silicon (a-Si:H) i layer, a hydrogenated amorphous silicon (a-Si:H) n layer, a transparent conductive film, and a back-side electrode are formed in this sequence on a transparent-insulative substrate.

In addition, in the above-described manner, an uneven configuration is formed on the surface of the glass substrate and, as a result of this, each of the transparent conductive film, the photoelectric conversion active layer, and the transparent conductive film that are stacked onto the top of the surface of the glass substrate have an uneven structure.

Recently, polyimide resins which have high heat resistance have come to be used for cases in which a semiconductor element such as a thin-film solar battery is to be formed on top of a flexible substrate or a lightweight substrate.

A method for forming irregularity in this type of resin is disclosed in, for example, Japanese Unexamined Patent Application, First Publication No. H04-61285.

Moreover, in Japanese Unexamined Patent Application, First Publication No. H11-274533, technology is disclosed in which light is retro-reflected by a V-groove periodic structure so that the light utilization efficiency increases. It is also disclosed that the apex angle of the V-grooves is desirably between 50° and 90°.

It is also disclosed that the pitch of the period of the V-grooves is desirably from 10 $\mu$m to 20 $\mu$m.

If the placement interval of the solar battery cells 401 is narrowed then this causes leakage current to occur.

Therefore, an area (i.e., an interval G) between mutually adjacent solar battery cells 401 is necessary.

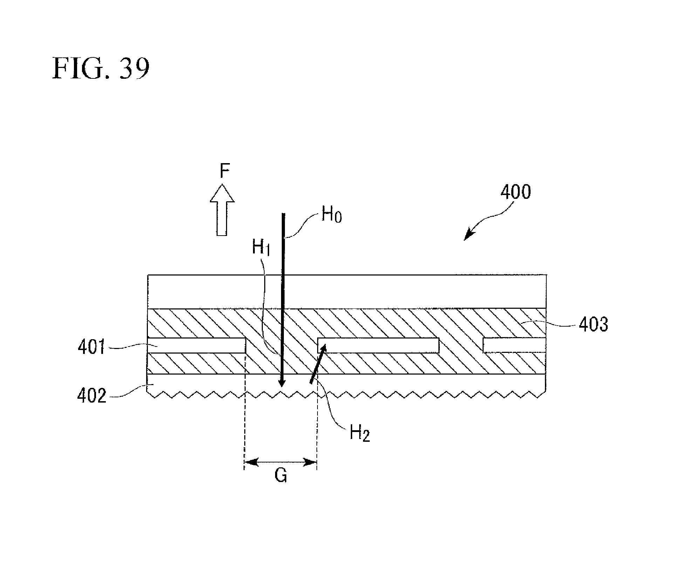

For example, as shown in FIG. 39, a structure is known in which a back-side component 402 is placed on a back surface of a solar battery module 400 (Japanese Unexamined Patent Application, First Publication No. H11-307791).

According to this structure, a portion H1 of light H0 which is incident to the solar battery module 400 travels into areas between mutually adjacent solar battery cells 401 and is reflected or scattered by the back-side component 402 so as to obtain light H2.

This light H2 is made to re-enter the solar battery cells 401 so that the light is reused.

However, in this type of structure, it is not possible to obtain a satisfactory power generation efficiency.

Additionally, in FIG. 39, reference numeral 403 denotes a packing layer, and a plurality of solar battery cells 401 are arrayed a predetermined distance apart from each other within this packing layer 403.

As described above, there have been many demands for the power generation efficiency per unit area of a conventional solar battery module to be raised, however, it is not been possible to obtain a satisfactory power generation efficiency because of the amount of light which is being lost.

Moreover, in the above-described conventional method, light incident to areas between mutually adjacent solar battery cells is reflected by a backside material thereby lost light is reused.

However, in this method, it has not hitherto been possible to satisfactorily reuse the lost light.

Therefore, it is strongly desired that this lost light be able to be more reliably reused, and that improvements in power generation efficiency be achieved.

SUMMARY OF THE INVENTION

The present invention was conceived in view of the above-described problems, and it is an object thereof to provide a light reuse sheet that makes it possible to improve light re-use efficiency by effectively reusing light which would have been conventionally lost, and a solar battery module in which this light reuse sheet is used.

In particular, it is an object of the present invention to provide a light reuse sheet which, in order to improve light reuse efficiency, has an optimum width of a solar battery cell, an optimum distance for the intervals G between mutually adjacent solar battery cells, optimum positions for the light reuse sheet and the solar battery cells, an optimum thickness for the solar battery module, and an optimum uneven configuration, and to provide a solar battery module in which this light reuse sheet is used.

Furthermore, it is an object of the present invention to provide a sheet that reuses the light of a light emitting element such as an LED or an EL element in which this light reuse sheet is used, and to provide a light emitting element that uses this sheet.

In order to achieve the object, a light reuse sheet of a first aspect of the invention includes a reflective surface having an uneven configuration. The reflective surface is formed so as to satisfy the following formula in order to reflect light in a specific direction so as to cause light to be incident to a solar battery cell, the light being incident to a solar battery module, or in order to exit light in a specific direction by reflecting the light, the light being emitted from a light emitting element of a light source module.

$$\text{(Formula 1)} \qquad \frac{df}{d\phi} = 0 = Ly \cdot \cos\phi - Lx \cdot \sin\phi - A(\cos^2\phi - \sin^2\phi)$$

Here, the length in the horizontal direction of the solar battery cell or the light emitting element is represented by Lx. The length in the vertical direction of the solar battery cell or the light emitting element is represented by Ly. An angle formed between the direction of an uneven configuration of the reflective surface and an edge in the horizontal direction of the solar battery cell or the light emitting element is represented by φ. The maximum width of light which passes between adjacent solar battery cells and which is reflected by the light reuse sheet and is incident to the light receiving face of the solar battery cell, or the maximum width of light which is not emitted from the light emitting element in the specific direction and which exits in the specific direction by reflecting the light at the light reuse sheet is represented by A.

In the light reuse sheet of the first aspect of the invention, it is preferable that the reflective surface be formed so as to satisfy φ = 45°±20° in a case where the length in the horizontal direction Lx of the solar battery cell or the light emitting element is equivalent to the length Ly in the vertical direction thereof, or in a case where a long side thereof is less than or equal to twice the short side thereof.

In the light reuse sheet of the first aspect of the invention, it is preferable that the reflective surface be formed so as to satisfy φ = 60°±20° (Lx < Ly) or φ = 30°±20° (Ly < Lx), in a case where the length in the horizontal direction Lx of the solar battery cell or the light emitting element is different from the length Ly in the vertical direction and a long side thereof is greater than or equal to twice the short side thereof.

In the light reuse sheet of the first aspect of the invention, it is preferable that a width in a horizontal direction or a vertical direction of the solar electron cell or the light emitting element be equivalent to the maximum width A of the light. In addition, it is preferable that the reflective surface be formed so as to satisfy φ = 0° when the width in the horizontal direction is equivalent to the maximum width A of the light, or the reflective surface be formed so as to satisfy φ = 90° when the width in the vertical direction is equivalent to the maximum width A of the light.

A solar battery module of a second aspect of the invention includes: a front-surface plate to which light is incident; a packing layer, through which the light passing through the front-surface plate passes; a solar battery cell which has a light receiving surface and a rear face opposite to the light receiving surface, which is fixed by the packing layer, and which converts the light passing through the packing layer into electricity by receiving the light at the light receiving surface; and a light reuse sheet which is disposed so as to face the rear face of the solar battery cell, and which reflects the light passing between the solar battery cell adjacent to each other and has a reflective surface having an uneven configuration that causes the solar battery cell to receive the light, wherein the light reuse sheet is the light reuse sheet of the above first aspect of the invention.

A light source module of a third aspect of the invention includes: a packing layer through which light passes, and which has an emission surface; a light emitting element fixed by the packing layer, having a light emitting surface and a rear face opposite to the light emitting surface, converting electricity into light, emitting the light from the light emitting surface, and causing the light to be reflected by the emission surface of the packing layer; and a light reuse sheet which is disposed so as to face the rear face of the light emitting element and which has a reflective surface having an uneven configuration, the uneven configuration causing the light reflected by the emission surface of the packing layer to be re-reflected toward the emission surface, wherein the light reuse sheet is the light reuse sheet of the above first aspect of the invention.

A solar battery module of a fourth aspect of the invention includes: a front-surface plate to which light is incident; a packing layer, through which the light passing through the front-surface plate passes; a solar battery cell which has a light receiving surface and a rear face opposite to the light receiving surface, which is fixed by the packing layer, and which converts the light passing through the packing layer into electricity by receiving the light at the light receiving surface; and a light reuse sheet which is disposed so as to face the rear face of the solar battery cell, and which has a reflective surface having an uneven configuration reflecting the light that is not received by the light receiving surface of the solar battery cell, wherein the reflective surface satisfies the following formula where a distance between the reflective surface of the light reuse sheet and the light receiving surface of the solar battery cell is represented by C, an angle formed between the light incident to the light reuse sheet and the light reflected by the light reuse sheet is represented by $\beta$, and an interval of a gap between solar battery cells is represented by G.

(Formula 2)

$$C \cdot \tan \beta < G$$

In the solar battery module of the fourth aspect of the invention, it is preferable that the reflective surface of the light reuse sheet satisfy the following formulas where a distance between the incident face of the solar battery module and the reflective surface of the light reuse sheet is represented by H and a width of the solar battery cell is represented by W.

(Formula 3)

$$(2H - C) \cdot \tan \beta - W \leq G \leq (2H - C) \cdot \tan \beta$$

or

(Formula 4)

$$(2H - C) \cdot \tan \beta \leq G$$

In the solar battery module of the fourth aspect of the invention, it is preferable that the reflective surface of the light reuse sheet satisfy the following formula.

(Formula 5)

$$G = (2H - C) \cdot \tan \beta$$

A solar battery module of a fifth aspect of the invention includes: a front-surface plate to which light is incident; a packing layer, through which the light passing through the front-surface plate passes; a solar battery cell which has a light receiving surface and a rear face opposite to the light receiving surface, which is fixed by the packing layer, and which converts the light passing through the packing layer into electricity by receiving the light at the light receiving surface; and a light reuse sheet which is disposed so as to face the rear face of the solar battery cell, and which has a reflective surface having an uneven configuration reflecting the light that is not received by the light receiving surface of the solar battery cell, wherein the solar battery module has the reflective surface satisfying the following formula where a distance between the reflective surface of the light reuse sheet and the light receiving surface of the solar battery cell is represented by C.

$$(\text{Formula } 6) \qquad C = 0$$

Effects of the Invention

In the present invention, it is possible to improve the reuse efficiency of light, and to improve the power generation efficiency of a solar battery module by effectively reusing light which would have been conventionally lost.
Furthermore, by using this light reuse sheet, it is possible to provide a light emitting element in which the light from a light emitting element such as an LED or an EL element is reused, and that has a superior light reuse efficiency and a superior light emitting efficiency.

BRIEF DESCRIPTION OF THE DRAWINGS

FIG. 1 is a cross-sectional view showing an example of a solar battery module of the present invention.
FIG. 2 is a cross-sectional view showing an example of a light reuse sheet of the present invention.
FIG. 3 is a cross-sectional view showing an example of a light reuse sheet of the present invention.
FIG. 4 is a cross-sectional view showing an example of a light reuse sheet of the present invention.
FIG. 5 is a cross-sectional view showing an example of a light reuse sheet of the present invention.
FIG. 6 is a cross-sectional view showing an example of a light reuse sheet of the present invention.
FIG. 7 is a view showing changes in reflectance relative to an incident angle.
FIG. 8A is a front view showing an example of a solar battery module.
FIG. 8B is a cross-sectional view showing an example of a solar battery module.
FIG. 9A is a front view showing an example of a solar battery module.
FIG. 9B is a cross-sectional view showing an example of a solar battery module.
FIG. 10 is a cross-sectional view showing an example of a solar battery module.
FIG. 11 is a front view showing an example of a solar battery module.
FIG. 12 is a view showing the size of an area of light which is incident to a solar battery cell when an angle of rotation of a light reuse sheet is changed.
FIG. 13 is a view showing an optimum angle of rotation of a light reuse sheet relative to the lengths of the solar battery cell.
FIG. 14 is a view showing the light reuse efficiency when a light reuse sheet is placed at the optimum angle of rotation for the lengths of the solar battery cell.
FIG. 15 is a front view showing an example of a solar battery module.
FIG. 16 is a view showing the size of an area of light which is incident to a solar battery cell when the angle of rotation of a light reuse sheet is changed.
FIG. 17 is a cross-sectional view showing an example of the solar battery module of the present invention.
FIG. 18 is a cross-sectional view showing an example of the solar battery module of the present invention.
FIG. 19 is a cross-sectional view showing the solar battery module of the present invention.
FIG. 20 is a cross-sectional view showing an example of the solar battery module of the present invention.
FIG. 21 is a view showing changes in reflectance relative to the incident angle.
FIG. 22 is a cross-sectional view showing an example of a light reuse sheet.
FIG. 23 is a cross-sectional view showing an example of a solar battery module.
FIG. 24 is a cross-sectional view showing an example of a solar battery module.
FIG. 25 is a cross-sectional view showing an example of the solar battery module of the present invention.
FIG. 26 is a cross-sectional view showing an example of the solar battery module of the present invention.
FIG. 27 is a cross-sectional view showing an example of the solar battery module of the present invention.
FIG. 28 is a cross-sectional view showing an example of the solar battery module of the present invention.

FIG. 29 is a cross-sectional view showing an example of the solar battery module of the present invention.

FIG. 30 is a view showing changes in the length of an area of light which is not incident onto a solar battery from among the intervals between solar battery cells.

FIG. 31 is a cross-sectional view showing an example of the solar battery module of the present invention.

FIG. 32 is a cross-sectional view showing an example of the light reuse sheet of the present invention.

FIG. 33 is a cross-sectional view showing an example of the light reuse sheet of the present invention.

FIG. 34 is a cross-sectional view showing an example of the light reuse sheet of the present invention.

FIG. 35 is a cross-sectional view showing an example of the light reuse sheet of the present invention.

FIG. 36 is a cross-sectional view showing an example of the solar battery module of the present invention.

FIG. 37 is a cross-sectional view showing an example of the solar battery module of the present invention.

FIG. 38 is a cross-sectional view showing a light source module of the present invention.

FIG. 39 is a cross-sectional view showing a light source module which uses a conventional back-side material.

DESCRIPTION OF THE PREFERRED EMBODIMENTS

Hereinafter, embodiments of the present invention will be described with reference to the drawings.

Additionally, in the respective drawings used in the description given below, the scale of each component has been suitably altered in order to make each component an easily recognizable size.

First embodiment

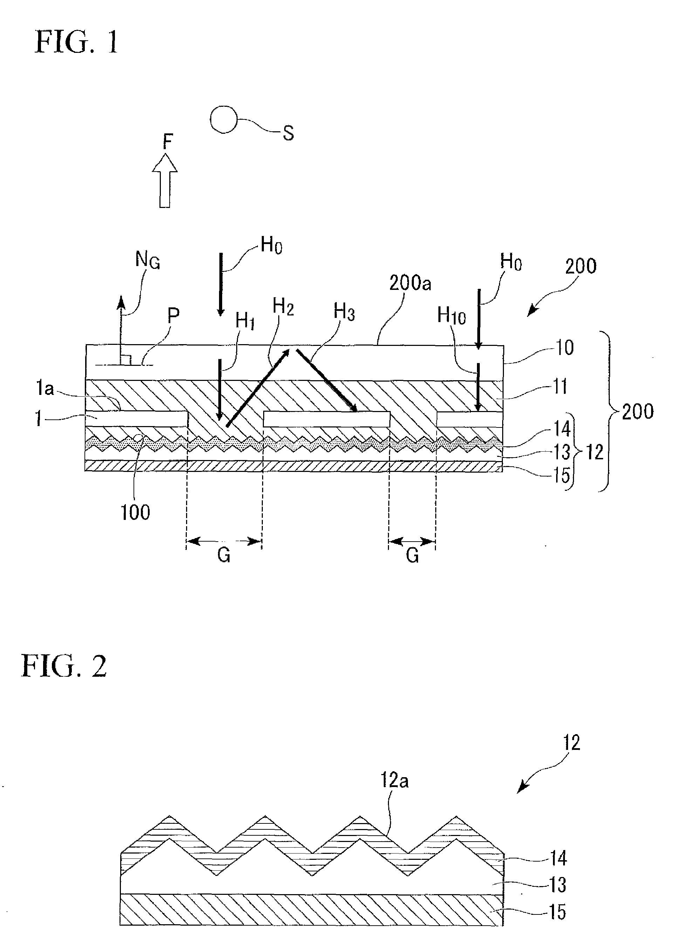

Hereinafter, a light reuse sheet, a solar battery module, and a light emitting element according to a first embodiment of the present invention will be described with reference to FIGS. 1 to 19.

Here, the first embodiment relates to a light reuse sheet that is used to deflect (i.e., reflect) light in a specific direction and thereby reuse light which would have been conventionally lost, and relates to a solar battery module which is provided with this light reuse sheet.

As shown in FIG. 1, a solar battery module 200 of the first embodiment is formed by a front-surface plate 10, a packing layer 11, and a light reuse sheet 12.

The front-surface plate 10 protects the solar battery cells 1 from impact, contamination, water ingress, and the like while allowing light from a light source S such as sunlight or illumination light to pass through, and is formed from a transparent material having a high light transmittance.

As a result of this, light H0 which is created when light from the light source S is perpendicularly incident to an incident surface 200a from the sunlight or illumination light side F is incident to the front-surface plate 10, passes through this front-surface plate 10, and is emitted into the packing layer 11.

Additionally, a normal line NG of the incident surface 200a extends in a direction which is parallel to a normal line of a plane P when the front-surface plate 10 is placed horizontally on the plane P. The light H0 which is perpendicularly incident to the incident surface 200a is light incident to the solar battery module 200 in parallel with this normal line NG.

Moreover, the front-surface plate 10 is formed using a glass such as toughened glass or sapphire glass, or using a resin sheet such as PC (polycarbonate) or PEN (polyethylene naphthalate).

Furthermore, if the front-surface plate 10 is toughened glass, the thickness of the front-surface plate 10 is set to approximately 3 to 6 mm.

If the front-surface plate 10 is a resin sheet, the thickness of the front-surface plate 10 is set to approximately 100 $\mu$m to 3000 $\mu$m.

The packing layer 11 to which the light exiting from the front-surface plate 10 is incident is a layer sealing the solar battery cells 1.

The light H0 which is incident to the front-surface plate 10 is transmitted through the packing layer 11 and becomes light H10 that is emitted toward the solar battery cells 1. Part of this light then becomes light H1 that is emitted onto the light reuse sheet 12.

This packing layer 11 is formed using a material having a high light transmittance such as, for example, EVA (ethylene vinyl acetate) having flame-resistant in order to allow the incidence light H0 to pass therethrough.

The solar battery cells 1 have a function of converting light incident to a light receiving surface 1 a into electricity by photoelectric effect.

A large number of different types of solar battery cells are used such as single-crystalline silicon solar batteries, polycrystalline silicon solar batteries, thin-film silicon solar batteries, and compound thin-film solar batteries such as CdTe (Cd-Te compound) based solar batteries and CIGS (Cu-In-Ga-Se compound) based solar batteries.

Moreover, a solar battery module 200 is formed by connecting electrodes of a plurality of the solar battery cells 1 with each other.

In addition, the light H10 which is incident to the solar battery cells 1 from the packing layer 11 is converted into electricity in the solar battery cells 1.

Here, normally, a greater proportion of the light which is incident diagonally onto the incident surface 200a is reflected by the incident surface 200a compared with the light H0 which is incident perpendicularly thereon, and a smaller quantity of this light is incident directly onto the solar battery cells 1 so that the quantity of light that can be used for power generation is reduced.

Because of this, when the incidence light H0 is incident substantially perpendicularly onto the incident surface 200a, the power generation efficiency is highest.

In contrast, as shown in FIGS. 1 and 2, the light reuse sheet 12 of the first embodiment is provided with a structural layer 13, a reflective layer 14, and a base 15.

One surface of the structural layer 13 is formed in an uneven configuration.

Examples of the method used to form an uneven configuration on the structural layer 13 include methods in which a thermosetting resin, an ultraviolet curable resin, or an electron beam curable resin or the like is either coated or injected onto a mold on which a surface corresponding to the uneven configuration of a reflective surface 12a has been formed. The base 15 is then placed on top of this, and curing processing is performed, after which the resin is released from the stamper mold.

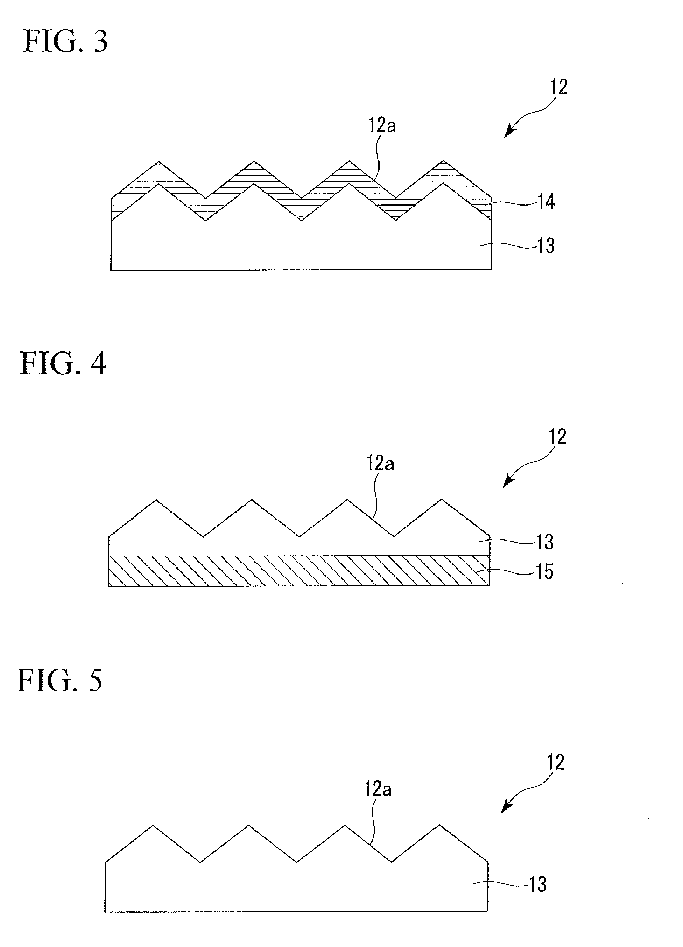

Here, as shown in FIG. 3, the light reuse sheet 12 may be formed of the structural layer 13 and the reflective layer 14 without using the base 15.

Examples of the manufacturing method used to mold this light reuse sheet 12 include a press method using a mold, a casting method, an injection molding method, and the like.

According to this method, it is possible to form the uneven configuration at the same time as the sheet is formed.

A mold manufactured by machine cutting can be employed for the mold used to form the reflective surface 12a.

Moreover, it is possible to use molds manufactured by making duplicates of the above-described mold.

In this case, it is desirable for the shape of the distal ends of the uneven configuration to be a rounded shape in order to prevent any damage occurring to the distal ends of the uneven configuration.

It is also possible for the uneven configuration of the reflective surface 12a to have a periodic structure.

Furthermore, the uneven configuration of the reflective surface 12a may also be a triangular, trapezoidal, or polygonal prism-shaped configuration, or various types of lens and prism configurations such as cylindrical lenses, or may be a semi-spherical configuration.

At this time, it is desirable that the pitch of the period of the structure of the uneven configuration of the reflective surface 12a be less than or equal to 300 $\mu$m, and more desirable for the pitch to be less than or equal to 200 $\mu$m.

Namely, if the pitch of the period of the structure is greater than 300 $\mu$m, there is a deterioration in moldability as it is difficult for resin to enter sufficiently into the mold in the distal end portions of the uneven configuration when the reflective surface 12a is being molded.

In contrast, if the pitch of the period of the structure is less than or equal to 200 $\mu$m, molding is still possible even with a resin having a comparatively high viscosity.

Moreover, the smaller the pitch of the period of the structure, the more difficult it is to manufacture the mold. Therefore, it is desirable for the pitch to be greater than or equal to 10 $\mu$m and more desirable for the pitch to be greater than or equal to 50 $\mu$m.

Namely, if the pitch of the period of the structure is less than 10 $\mu$m, the time needed to cut the mold increases so that there is a deterioration in the takt time and also in productivity.

If the pitch of the period of the structure is less than 50 $\mu$m, then the resin does not properly fill the trenches of the uneven configuration when the reflective surface 12a is being molded, and it is not possible to make the shape of the distal end portions of the uneven configuration so as to conform properly to the mold.

Furthermore, the thickness of the structural layer 13 is not particularly limited, however, considering the height of the structure of the uneven configuration, the thickness may be, for example, from 30 $\mu$m to 500 $\mu$m.

Additionally, the aforementioned manufacturing method may be appropriately selected based on suitability for use with the following materials.

In the polymer composition used to form the structural layer 13, it is also possible to appropriately mix in, for example, a scattering reflector, a curing agent, a plasticizer, a dispersing agent, various types of leveling agent, ultraviolet ray absorption agents, antioxidants, viscosity modifiers, lubricants, and photostabilizers, and the like, in addition to the polymer composition.

Moreover, the above-described polymer composition is not particularly limited and examples thereof include poly (meth) acrylic resins, polyurethane resins, fluorine resins, silicone resins, polyimide resins, epoxy resins, polyethylene resins, polypropylene resins, methacrylic resins, polymethylpentene resins, cyclic polyolefin resins, polystyrene resins such as acrylonitrile (poly) styrene copolymers (AS resins) and acrylonitrile-butadiene-styrene copolymers (ABS resins), polyvinyl chloride resins, polycarbonate resins, polyester resins, polyamide resins, polyamide imide resins, polyarylphthalate resins, polysulfone resins, polyphenylene sulfide resins, polyether sulfone resins, polyethylene naphthalate resins, polyether imide resins, acetal resins, cellulose resins, and the like, and these polymers may be used either singly or in combinations of two or more.

Examples of the polyol which forms the raw material of the polyurethane resin include polyols obtained by polymerizing monomeric components that include hydroxyl-containing unsaturated monomers, or polyester polyols obtained in conditions of excessive hydroxyl, and these may be used either singly or in combinations of two or more.

Examples of the hydroxyl-containing unsaturated monomer include hydroxyl-containing unsaturated monomers obtained from a reaction between (a) hydroxyl-containing unsaturated monomers such as, for example, 2-hydroxyethyl acrylate, 2-hydroxypropyl acrylate, 2-hydroxyethyl methacrylate, 2-hydroxypropyl methacrylate, allyl alcohol, homoallylic alcohol, cinnamic alcohol, and crotonyl alcohol; and (b) dihydric alcohols or epoxy compounds such as, for example, ethylene glycol, ethylene oxide, propylene glycol, propylene oxide, butylene glycol, butylene oxide, 1,4-bis (hydroxymethyl) cyclohexane, phenyl glycidyl ether, glycidyl decanoate, and Placcel FM-1 (manufactured by Daicel Chemical Industries, Ltd.); and unsaturated carboxylic acids such as, for example, acrylic acid, methacrylic acid, maleic acid, fumaric acid, crotonic acid, and itaconic acid.

It is possible to manufacture a polyol by polymerizing one or two or more of these hydroxyl-containing unsaturated monomers.

Moreover, the above-described polyol can be manufactured by polymerizing one or two or more ethylenic unsaturated monomers selected from: ethyl acrylate, n-propyl acrylate, isopropyl acrylate, n-butyl acrylate, tert-butyl acrylate, ethylhexyl acrylate, ethyl methacrylate, n-propyl methacrylate, isopropyl methacrylate, n-butyl methacrylate, tert-butyl methacrylate, ethylhexyl methacrylate, glycidyl methacrylate, cyclohexyl methacrylate, styrene, vinyl toluene, 1-methyl styrene, acrylic acid, methacrylic acid, acrylonitrile, vinyl acetate, vinyl propionate, vinyl stearate, allyl acetate, diallyl adipate, diallyl itaconate, diethyl maleate, vinyl chloride, vinylidene chloride, acrylamide, N-methylolacrylamide, N-(butoxymethyl) acrylamide, diacetone acrylamide, ethylene, propylene, and isoprene and the like; and a hydroxyl-containing unsaturated monomer selected from the above (a) and (b).

Here, the number-average molecular weight of the polyol obtained by polymerizing a monomeric component containing a hydroxyl-containing unsaturated monomer is from 1000 to 500000, and preferably is from 5000 to 100000.

Moreover, the hydroxyl value thereof is from 5 to 300, and preferably from 10 to 200, and more preferably from 20 to 150.

The polyester polyol obtained in conditions of excessive hydroxyl is manufactured by generating a reaction between: (c) polyhydric alcohols such as, for example, ethylene glycol, diethylene glycol, propylene glycol, dipropylene glycol, 1,3-butanediol, 1,4-butanediol, 1,5-butanediol, neopentyl glycol, hexamethylene glycol, decamethylene glycol, 2,2,4-trimethyl-1,3-pentanediol, trimethylolpropane, hexanetriol, glycerin, pentaerythritol, cyclohexanediol, hydrogenated bisphenol A, bis (hydroxymethyl) cyclohexane, hydroquinone bis (hydroxyethyl ether), tris (hydroxyethyl) isocyanurate, and xylylene glycol and; (d) polybasic acids such as, for example, maleic acid, fumaric acid, succinic acid, adipic acid, sebacic acid, azelaic acid, trimellitic acid, terephthalic acid, phthalic acid, and isophthalic acid and the like under the condition that the hydroxyl group number in the polyhydric alcohol such as propanediol, hexanediol, polyethylene glycol, and trimethylolpropane and the like is greater than the carboxyl group number of the polybasic acid.

The number-average molecular weight of the polyester polyol obtained under the above-described excessive hydroxyl conditions is from 500 to 300000, and preferably is from 2000 to 100000.

Moreover, the hydroxyl value thereof is from 5 to 300, and preferably is from 10 to 200, and more preferably is from 20 to 150.

The polyol that is used as the polymer material of the polymer composition is preferably the above-described polyester polyol, or an acrylic polyol which is obtained by polymerizing the above-described monomeric component containing a hydroxyl-containing unsaturated monomer, and which has a (meth) acrylic unit or the like.

If a polyester polyol or an acrylic polyol is used for the polymer material, then superior durability is obtained and any yellowing of the structural layer 3 can be inhibited.

Additionally, either one of these polyester polyols and acrylic polyols may be used, or else both may be used.

The number of hydroxyl groups in the above-described polyester polyols and acrylic polyols is not particularly limited, as long as the number is two or more per molecule.

If the hydroxyl value in the solid portion is 10 or less, there is a reduction in the number of cross-linking points and there is a tendency for the solvent resistance, water resistance, heat resistance, and coating properties such as surface hardness and the like to all deteriorate.

Furthermore, it is also possible to include a scattering reflector in the polymer composition which is used to form the structural layer 13 in order to improve the reflection properties, and the heat resistance thereof.

By including a scattering reflector in the polymer composition, the heat resistance of the structural layer 13 or the light reuse sheet 12 can be improved, and if a material having a refractive index which is considerably different from that of the polymer composition is used for the scattering reflector, then light can be reflected.

Additionally, if sufficient reflectance can be obtained in this manner, then, as shown in FIGS. 4 and 5, it is not necessary to provide the reflective layer (i.e., the metal reflective layer) 14.

The inorganic substance that makes up the scattering reflector is not particularly limited.

An inorganic oxide is preferably used as the inorganic substance.

Silica and the like can be used for this inorganic oxide, and hollow grains of silica can also be used.

In addition, metallic compounds such as ZnS and the like can also be used and, in this case, metallic oxides such as $TiO_2$ ZrO, and $Al_2O_3$ and the like are particularly desirable.

Of these, $TiO_2$ is preferable due to high refractive index and easily obtained dispersibility.

Furthermore, the shape of the scattering reflector is not particularly limited and the grains may be an optional shape such as a spherical shape, needle shape, plate shape, fish scale shape, or as fractured pieces.

The lower limit of the mean grain diameter of the scattering reflector is preferably 0.1 μm, and the upper limit thereof is preferably 30 μm.

If the mean grain diameter is less than 0.1 μm, light is not sufficiently reflected.

On the other hand, if the mean grain diameter is greater than 30 μm, then irregularities caused by the grains appear on the surface and it is difficult to form a desired uneven configuration.

The lower limit for the blending quantity of scattering reflector blended into 100 parts of the polymer composition is preferably 30 parts in terms of solid content.

In contrast, the upper limit for the blending quantity of scattering reflector is preferably 100 parts.

The reason for this is that, if the blending quantity of inorganic filling agent is less than 30 parts, the light H1 which is incident to the structural layer 12 from the packing layer 11 cannot be sufficiently reflected.

Conversely, if the blending quantity is greater than 100 parts, there is a deterioration in moldability.

A material having an organic polymer fixed to the surface thereof may be used as the above-described scattering reflector.

By using a scattering reflector to which an organic polymer has been fixed in this manner, improvements in the scattering performance in the polymer composition and in the affinity with the polymer composition are achieved.

The molecular weight, shape, composition, the presence or absence, or the like of a functional group and the like are not particularly restricted in this organic polymer, and a desired organic polymer can be used.

Moreover, a desired configuration such as a linear configuration, branched configuration, cross-linked structure, or the like can be used for the configuration of this organic polymer.

Specific examples of the resin making up the above-described organic polymer include polyolefins such as (meth) acrylic resin, polystyrene, polyvinyl acetate, and polyethylene, polyesters such as polyvinyl chloride, polyvinylidene chloride, and polyethylene terephthalate as well as copolymers of these, as well as resins partially denatured by a functional group such as an amino group, and epoxy group, a hydroxyl group, and a carboxyl group.

Among these, materials which have as their essential component an organic polymer containing a (meth) acrylic unit such as a (meth) acrylic resin, a (meth) acrylic-styrene resin, or a (meth) acrylic-polyester resin have a coating formation function and are, therefore, preferred.

Specific resins for forming the organic polymer are preferably resins that are compatible with the above-described polymer compositions and, accordingly, a material that has the same composition as the polymer composition is most preferable.

A polyol having a cycloalkyl group is preferable as the above-described polymer composition.

By introducing a cycloalkyl group into the polyol which is serving as the polymer composition, the hydrophobicity, for example, the water repellency and water resistance and the like of the polymer composition increases, and the flexural resistance and dimensional stability and the like of the structural layer 13 and the light reuse sheet 12 under high-temperature and high-humidity conditions are improved.

In addition, basic coating properties such as the weather resistance, hardness, and solvent resistance of the structural layer 13 are improved.

Furthermore, the affinity thereof with a scattering reflector having an organic polymer fixed to the surface thereof, as well as the dispersibility of the scattering reflector are improved.

It is also possible for an isocyanate to be included in the polymer composition as a curing agent.

By including an isocyanate curing agent in the polymer composition in this manner, a stronger cross-linked structure is obtained, and the coating properties of the structural layer 13 are further improved.

The same type of materials as the above-described polyfunctional isocyanate compounds are used as this isocyanate.

Among these, an aliphatic isocyanate which prevents yellowing of the coating is preferable.

Additionally, the scattering reflector may also include an internal organic polymer.

By employing this structure, a suitable consistency and toughness can be imparted to the inorganic substance forming the core of the scattering reflector.

An alkoxy group is preferably included in the above-described organic polymer and, while the content thereof is not particularly restricted, it is preferably from 0.01 mmol to 50 mmol per gram of scattering reflector.

The affinity of the organic polymer with the polymer composition, as well as the dispersibility of the organic polymer in the polymer composition are improved by this alkoxy group.

The above-described alkoxy group shows an RO group which is coupled to a metallic element forming a fine grain lattice.

This R is a substitutable alkyl group, and the RO group in the fine particles may be the same or may be different.

Specific examples of the R include methyl, ethyl, n-propyl, isopropyl, and n-butyl and the like.

It is preferable to use the same metal alkoxy group as the metal used to make up the scattering reflector, while if the scattering reflector is colloidal silica, it is preferable to use an alkoxy group having silicon as its metal.

In the scattering reflector to which an organic polymer is fixed, the content of the organic polymer is not particularly restricted, however, using the scattering reflector as a reference, it is preferably from 0.5% by mass to 50% by mass.

Moreover, as shown in FIGS. 1 and 2, when the light reuse sheet 12 is constructed using the reflective layer 14, in order to improve the tightness of the adhesive bond between them, surface processing may be performed on the surface onto which the reflective layer 14 is to be vapor-deposited (i.e., the surface of the structural layer 13).

Examples of this type of surface processing include: (a) corona discharge processing, ozone processing, low temperature plasma processing using oxygen gas or nitrogen gas, glow discharge processing, and oxidation processing using chemical agents and the like; (b) primer coating processing, undercoat processing, anchor coating processing, and vapor deposition anchor coating processing.

Among these surface processings, corona discharge processing and anchor coating processing are preferable as they provide improved adhesion strength with the reflective layer 14, and contribute to the formation of a precise and uniform reflective layer 14.

Examples of the anchor coating agent used in the aforementioned anchor coating processing include polyester-based anchor coating agents, polyamide-based anchor coating agents, polyurethane-based anchor coating agents, epoxy-based anchor coating agents, phenol-based anchor coating agents, (meth) acrylic-based anchor coating agents, polyvinyl acetate-based anchor coating agents, polyolefin-based anchor coating agents such as polyethylene and polypropylene, and cellulose-based anchor coating agents.

Among these anchor coating agents, polyester-based anchor coating agents are particularly preferable as they make it possible to further improve the adhesion strength of the reflective layer 14.

The coating quantity (in terms of solid content) of the aforementioned anchor coating agents is preferably from 1 g/m$^2$ to 3 g/m$^2$.

If the coating quantity of the anchor coating agent is less than 1 g/m$^2$, the effectiveness of the improvement in the adhesion of the reflective layer 14 is diminished.

If, however, the coating quantity of the anchor coating agent is greater than 3 g/m$^2$, there is a possibility that the strength and durability and the like of the light reuse sheet 12 will deteriorate.

Additionally, in the above-described anchor coating agent it is also possible to suitably blend various additives such as a silane coupling agent which is used to improve the tightness of the adhesive bond, a blocking inhibitor which is used to prevent blocking, and an ultraviolet ray absorption agent which is used to improve the weatherproofness and the like thereof:

The blending quantity of these additives is preferably from 0.1% by weight to 10% by weight in order to maintain a balance between manifesting the effect of the additives and functional inhibition of the anchor coating agent.

If the blending quantity of the above-described additives is less than 0.1% by weight, then it is not possible to satisfactorily prevent blocking and sufficient weatherproofness cannot be obtained. On the other hand, if the blending quantity is greater than 10% by weight, the functions of the top coating agent are inhibited.

The reflective layer 14 is a layer that reflects light which is incident to the light reuse sheet 12, and is formed, for example, by vapor-depositing a metal over the surface of the structural layer 13 on which the uneven configuration is formed.

The vapor deposition apparatus which is used to form the reflective layer 14 is not particularly restricted provided that it is able to vapor-deposit a metal without this leading to any deterioration such as contraction or yellowing of the structural layer 13.

(a) Physical vapor deposition (PVD) methods such as a vacuum deposition method, a sputtering method, an ion plating method, and an ion cluster beam method and the like, and (b) Chemical vapor deposition (CVD) methods such as a plasma chemical vapor deposition method, a thermal chemical vapor deposition method, and a photochemical vapor deposition method and the like are employed.

Among these deposition methods, a vacuum deposition method or an ion plating method are preferable as they have high productivity and make it possible to form a superior reflective layer 4.

Moreover, the metal which is used for the reflective layer 14 is not particularly restricted provided that it has metallic luster and can be vapor-deposited.

Examples of the metal used for the reflective layer 14 include aluminum, silver, gold, nickel, tin, zirconium and the like.

Among these, aluminum is preferable as it is highly reflective and allows a precise reflective layer 14 to be formed comparatively easily.

Additionally, the reflective layer 14 may be a single layer structure or may be a multilayer structure made up of two or more layers.

If the reflective layer 14 is a multilayer structure, there is less deterioration of the structural layer 13 due to the lessening of the thermal load generated during the vapor deposition, and the adhesiveness between the structural layer 13 and the reflective layer 14 can be further improved.

Moreover, at this time, it is also possible to provide a metal oxide layer on top of the metal film.

Furthermore, the vapor deposition conditions in the above-described physical vapor deposition method and chemical vapor deposition method are suitably designed in accordance with the types of resin used for the structural layer 13 and the base 15, and with the thickness of the reflective layer 14 and the like.

The lower limit for the thickness of the reflective layer 14 is preferably 10 nm, and 20 nm is particularly preferable.

The upper limit for the thickness of the reflective layer 14 is preferably 200 nm, and 100 nm is particularly preferable.

If the thickness of the reflective layer 14 is less than the lower limit of 10 nm, then it is no longer possible to satisfactorily reflect light which is incident to the reflective layer 14 from the packing layer 11.

Moreover, even if the thickness is greater than 20 nm, there is no increase in the amount of light reflected by the reflective layer 14 so that a thickness of 20 nm can be said to be sufficient.

On the other hand, if the thickness of the reflective layer 14 is greater than the upper limit of 200 nm, cracks that are visually confirmed occur in the reflective layer 14.

Moreover, it is beneficial for top coat processing to be performed on the outer surface of the reflective layer 14.

By performing top coat processing on the outer surface of the reflective layer 14, the reflective layer 14 is sealed and protected, so that, as a result, the ease of handling the light reuse sheet 12 is improved.

Moreover, deterioration over time of the reflective layer 14 is suppressed. Examples of the top coating agent used in the above-described top coat processing include polyester-based top coating agents, polyamide-based top coating agents, polyurethane-based top coating agents, epoxy-based top coating agents, phenol-based top coating agents, (meth) acrylic-based top coating agents, polyvinyl acetate-based top coating agents, polyolefin-based top coating agents such as polyethylene and polypropylene, and cellulose-based top coating agents.

Among these top coating agents, polyester-based top coating agents are particularly preferable as they have a high adhesion strength with the reflective layer 14, and they contribute to protecting the surface of the reflective layer 14 and also to sealing any defects and the like.

The coating quantity (in terms of solid content) of the aforementioned top coating agents is preferably from 3 $g/m^2$ to 7 $g/m^2$.

If the coating quantity of the anchor coating agent is less than 3 $g/m^2$, the effectiveness of the sealing and protection of the reflective layer 14 is diminished.

However, even if the coating quantity of the anchor coating agent is greater than 7 $g/m^2$, there is essentially no further increase in the sealing and protection effect of the reflective layer 14, while there is an increase in the thickness of the light reuse sheet 12.

Additionally, in the above-described top coating agent, it is also possible to suitably blend various additives such as a silane coupling agent which is used to improve the tightness of the adhesive bond, an ultraviolet ray absorption agent which is used to improve weatherproofness and the like, and an inorganic filler or the like which is used to improve heat resistance and the like.

The blending quantity of these additives is preferably from 0.1% by weight to 10% by weight in order to maintain a balance between manifesting the effect of the additives and functional inhibition of the top coating agent.

If the blending quantity of the above-described additives is less than 0.1% by weight, then it is not possible to obtain satisfactory adhesiveness, weatherproofness, and heat resistance. On the other hand, if the blending quantity is greater than 10% by weight, the functions of the top coating agent are inhibited.

The base 15 which forms part of the light reuse sheet 12 is formed by sheet molding using synthetic resin as the material.

In view of the fact that it will be located outdoors, the synthetic resin used for the base 15 is desirably a material having weatherproof properties such as water resistance and durability against ultraviolet rays.

Examples thereof include polyethylene resins such as polyethylene terephthalate resin (PET resin), polypropylene resins, (meth) acrylic resins, polymethylpentene resins, cyclic polyolefin resins, polystyrene resins, acrylonitrile (poly) styrene copolymers (AS resins), acrylonitrile-butadiene-styrene copolymers (ABS resins), polyvinyl chloride resins, fluorine resins, poly (meth) acrylic resins, polycarbonate resins, polyester resins, polyamide resins, polyimide resins, polyamide imide resins, polyarylphthalate resins, silicone resins, polysulfone resins, polyphenylene sulfide resins, polyether sulfone resins, polyethylene naphthalate resins, polyether imide resins, epoxene resins, polyurethane resins, acetal resins, and cellulose resins and the like.

Among the above resins, polyimide reins, polycarbonate resins, polyester resins, fluorine resins, and polylactic acid resins are preferable as resins that have high heat resistance, strength, weatherproofness, durability, and gas barrier properties against water vapor and the like.

Examples of the aforementioned polyester resins include polyethylene terephthalate and polyethylene naphthalate and the like.

Among these polyester resins, polyethylene terephthalate is particularly preferable due to its excellent balance between its various functionalities such as heat resistance and weatherproofness and its low cost.

Examples of the aforementioned fluorine resins include polytetrafluoroethylene (PTFE), perfluoroalkoxy resin (PFA) formed by a copolymer of tetrafluoroethylene and perfluoroalkyl vinyl ether, a copolymer of tetrafluoroethylene and hexafluoropropylene (FEP), a copolymer of tetrafluoroethylene, perfluoroalkyl vinyl ether, and hexafluoropropylene (EPE), a copolymer of tetrafluoroethylene and ethylene or propylene (ETFE), polychlorotrifluoroethylene resin (PCTFE), a copolymer of ethylene and chlorotrifluoroethylene (ECTFE), polyvinylidene fluoride resin (PVDF), and polyvinyl fluoride resin (PVF).

Among these fluorine resins, polyvinyl fluoride resin (PVF) and a copolymer of tetrafluoroethylene and ethylene or propylene (ETFE) are particularly preferable due to their superior strength, heat resistance, and weatherproofness.

Examples of the aforementioned cyclic polyolefin resins include: (a) polymers obtained by polymerizing cyclic dienes such as cyclopentadiene (and derivatives thereof), dicyclopentadiene (and derivatives thereof), cyclohexadiene (and derivatives thereof), and norbomadiene (and derivatives thereof); and (b) copolymers obtained by polymerizing a cyclic diene with one or two or more olefin-based monomers such as ethylene, propylene, 4-methyl-1-pentene, styrene, butadiene, and isoprene.

Among these cyclic olefin resins, polymers of cyclic dienes such as cyclopentadiene (and derivatives thereof), dicyclopentadiene (and derivatives thereof), and norbomadiene (and derivatives thereof) are particularly preferable due to their superior strength, heat resistance, and weatherproofness.

Additionally, either one of the above-described synthetic resins, or two or more mixed together can be used as the material forming the base 15.

In addition, in the material used to form the base 15 it is also possible to blend various additives in order to improve and refine the workability, heat resistance, weatherproofness, mechanical properties, and dimensional stability and the like thereof.

Examples of such additives include lubricants, cross-linking agents, anti-oxidants, ultraviolet ray absorption agents, photostabilizers, filling materials, reinforcing fibers, reinforcing agents, antistatic agents, flame retardants, fire retardants, foaming agents, fungicides, pigments and the like.

The method used to form the base 15 is not particularly restricted and a known method may be used such as, for example, an extrusion method, a cast molding method, a T-die casting method, a cutting method, and an inflation method.

If the base 15 is used, then the thickness thereof is preferably from 25 $\mu$m to 500 $\mu$m, and, more preferably, less than or equal to 250 $\mu$m.

If the thickness of the base 15 is thinner than 25 $\mu$m, curling is generated during the coating processing of the structural layer 13 from the effects of curing contraction of the ultraviolet curable resin and the like, and defects occur when the solar cell is assembled into the solar battery module 200.

Conversely, if the thickness of the base 15 is greater than 500 $\mu$m, the weight of the film increases, so that the weight of the solar battery module 200 also increases.

If the thickness is less than or equal to 250 $\mu$m, then a more lightweight solar battery module 200 can be achieved.

It is also possible to include an ultraviolet stabilizer or a polymer having an ultraviolet stabilizer group coupled to the molecular chain thereof in the base 15 or the structural layer 13.

Radicals and active oxygen and the like are generated by ultraviolet rays are deactivated by the ultraviolet stabilizer or the ultraviolet stabilizer group, and it is thereby possible to improve the ultraviolet stability and the weatherproofness and the like of the light reuse sheet 12.

Hindered amine-based ultraviolet stabilizers or hindered amine-based ultraviolet stabilizer groups which have excellent stability against ultraviolet rays are preferably used as the ultraviolet stabilizer or ultraviolet stabilizer group.

As shown in FIG. 1, the solar battery module 200 of the first embodiment which is provided with the light reuse sheet 12 having the above-described structure has the function of reflecting light which has passed through the solar battery cells 1 themselves, and the light H1 which is incident (into the gaps G) between mutually adjacent solar battery cells 1 by the reflective surface 12a having an uneven structure.

The reflected light H2 is once again reflected by the boundary face between the front-surface plate 10 and the external atmosphere and the like so as to become light H3 which is incident to the light receiving surfaces 1a of the solar battery cells 1 and is photoelectrically converted.

As a result of this, compared with a structure in which there is no light reuse sheet 12, as a result of being provided with the light reuse sheet 12, the solar battery module 200 of the first embodiment reflects light that passes (through the gaps G) between mutually adjacent solar battery cells 1 and would have been conventionally lost, and causes this conventionally lost light to once again be incident to the light receiving surfaces 1a of the solar battery cells 1. Accordingly, the effect is obtained that the light utilization efficiency is improved.

Moreover, at this time, the direction in which the reflection light H2 travels can be controlled by the uneven structure of the reflective surface 12a, and a considerable quantity of the light can be incident to the light receiving surfaces 1 a.

Here, the uneven structure of the reflective surface 12a will be described using a normal line N0 thereof.

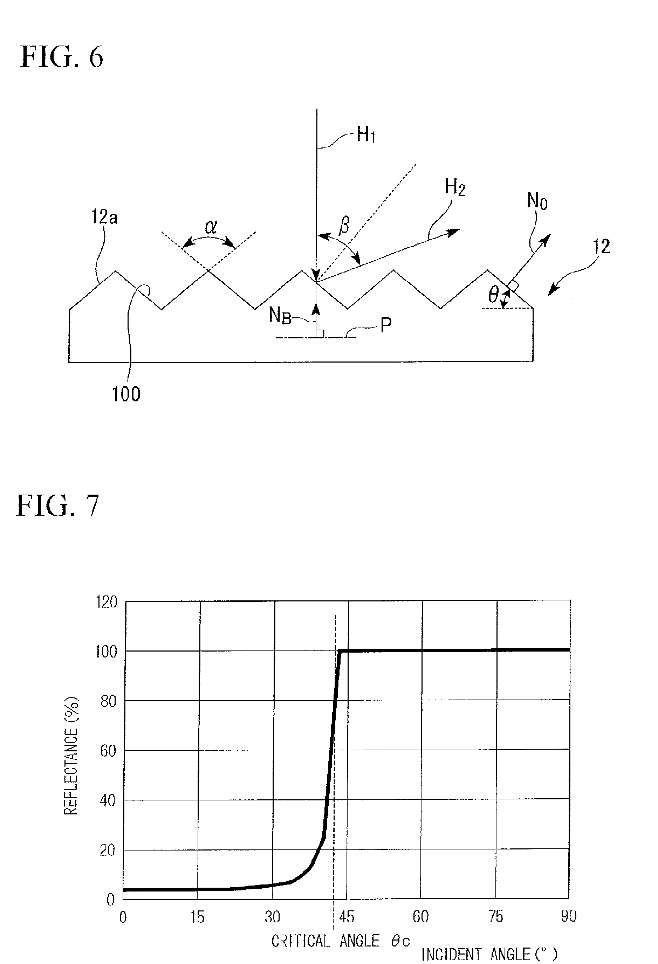

Additionally, as shown in FIG. 6, the normal line N0 of the reflective surface 12a is a straight line that intersects a tangential plane at any point on the reflective surface 12a.

Moreover, an angle θ of the reflective surface 12a is an angle of intersection between the normal line N0 of the reflective surface 12a and the sheet normal line NB.

Normally, because the sheet normal line NB is positioned so as to be parallel with the normal line NG of the incident surface 200a, the incidence light H1 is incident in parallel with the sheet normal line NB.

As shown in FIG. 7, the reflectance of the reflection light H2 changes greatly depending on the angle of incidence thereof onto the incident surface 200a.

Moreover, it is also known that the reflectance changes considerably taking the critical angle θc as a boundary.

If the reflectance of the front-surface plate 10 is represented as ng, this critical angle θc is expressed by Equation (1), while at an angle greater than this critical angle θc, all of the light H2 which is incident to the incident surface 200a is reflected by the incident surface 200a.

(Formula 7)

$$\theta_C = \arcsin(1/ng) \cdots (1)$$

Moreover, if ne is the refractive index of the packing layer 11, and θ2 is the angle of the reflection light H2 relative to the normal line NG, then by Snell's law, the relationship shown in Equation (2) is established between the critical angle θc and the angle θ2 of the reflection light H2 relative to the normal line NG.

(Formula 8)

$$ng \cdot \sin \theta_C = ne \cdot \sin \theta_2 \cdots (2)$$

From Equations (2) and (3), the angle θ2 of the reflection light H2 relative to the normal line NG changes to Equation (3).

(Formula 9)

$$\theta_2 = \arcsin(1/ne) \cdots (3)$$

Additionally, when the packing layer 11 is made up of a plurality of layers, if N0 is the refractive index of the material on the top of the reflective surface 12a, in the same way as described above, the angle θ2 of the reflection light H2 relative to the normal line NG changes to Equation (4).

(Formula 10)

$$\theta_2 = \arcsin(1/no) \cdots (4)$$

If the angle of the reflective surface 12a is θ, θ2 changes to Equation (5).

(Formula 11)

$$\theta_2 = 2 \cdot \theta \cdots (5)$$

If the angle θ of the reflective surface 12a is expressed by Equation (6), all of the reflection light H2 is reflected onto the front-surface plate 10.

(Formula 12)

$$2 \cdot \theta \geq \arcsin(1/no) \cdots (6)$$

The light reuse sheet 12 has a function of reflecting the light H1 that is incident (into the gaps G) between the solar battery cells 1 by the reflective surface 12a.

Because of this, the reflection light H2 is once again reflected by the boundary face between the front-surface plate 10 and the external atmosphere and the like so as to become the light H3 which is incident to the light receiving surfaces 1a of the solar battery cells 1 and is photoelectrically converted.

As a result of this, compared with a structure in which there is no light reuse sheet 12, the effect is obtained that the light utilization efficiency is improved.

On the other hand, the effect obtained from the light reuse sheet 12 is only evident when the relationship between the lengths and placement of the solar battery cells 1 and light reuse sheet 12 and the angle β between the incidence light H1 and the emission light H2 is within a suitable range.

The solar battery module 200 has a two-dimensional array of the solar battery cells 1.

Because of this, the light reuse sheets 12 can be provided in a vertical direction, a horizontal direction, or a diagonal direction.

By installing light reuse sheets 12 at an appropriate angle while considering the relationship between the spacings in the vertical direction and horizontal direction, the effect therefrom can be heightened.

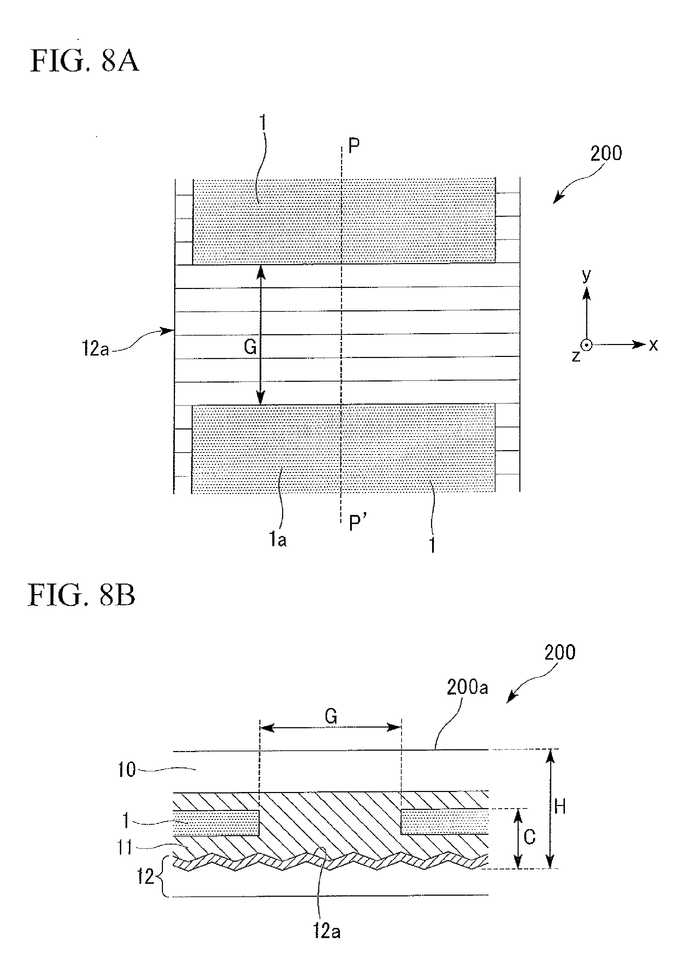

Hereinafter, with reference made to FIGS. 8A to 13, a description will be given of each instance when the lengths, placement, and rotation angle of the above-described solar battery cells 1 and light reuse sheet 12 are respectively altered, namely, of each instance when the gap G between the solar battery cells 1, areas A of the gaps G between the solar battery cells 1 where the reflection light H2 is incident to the light receiving surface 1a, and vertical and horizontal lengths Lx and Ly of the solar battery cells 1 are respectively altered.

Additionally, in FIGS. 8A to 13, because the description concerns relationships between the lengths, the placement, and the angle β between the incidence light H1 and the emission light H2, in some cases the uneven configuration of the reflective surface 12a of the light reuse sheet 12 is not shown in the drawings.

In FIG. 8A, the direction of the uneven configuration of the light reuse sheet 12 is matched to the spaces in the longitudinal direction (i.e. the x direction in the drawing) of mutually adjacent solar battery cells 1 in the gaps G between adjacent solar battery cells 1 which have been installed vertically (i.e., the y direction in the drawing).

FIG. 8B shows the cross-sectional structure at a line P-P' in FIG. 8A.

A portion of the light which is incident to in direct front of the solar battery cells 1 (i.e., from a + z direction) is incident to the light reuse sheet 12 and is reflected in the y direction (within a plane that determines PP' and z), and is then once again reflected by the front-surface plate 10 so as to arrive at the solar battery cells 1.

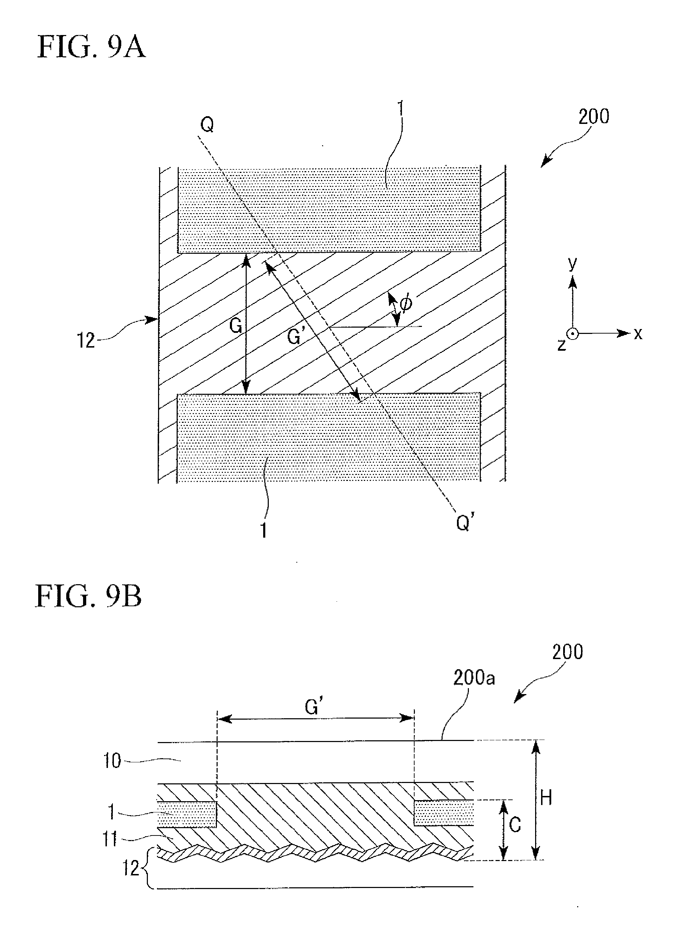

In FIG. 9A, the direction of the uneven configuration of the light reuse sheet 12 is not matched to the spaces in the longitudinal direction of mutually adjacent solar battery cells 1, but is arranged at a rotation angle φ (i.e., an angle between the direction of the uneven configuration of the light reuse sheet 12 and the edges in the horizontal direction of the solar battery cells 1) (i.e. at an angle from the x direction in the drawing) in the gaps G between adjacent solar battery cells 1 which have been installed vertically (i.e., the y direction in the drawing).

FIG. 9B shows the cross-sectional structure at a line Q-Q' in FIG. 9A.

The line Q-Q' is perpendicular (i.e., at 90°) to the rotation angle φ of the light reuse sheet 20.

G' is greater than the gap G between mutually adjacent solar battery cells 1.

Here, a portion of the light which is incident to in direct front of the solar battery cells 1 (i.e., from a + z direction) is incident to the light reuse sheet 12 and is reflected in the y + φ direction (within a plane that determines QQ' and z), and is then once again reflected by the front-surface plate 10 so as to arrive at the solar battery cell 1.

Additionally, because a symmetrical relationship exists, the range of the rotation angle φ is limited by Equation (7).

(Formula 13)

$$0 \leq \phi \leq 90 \cdots (7)$$

If FIGS. 8B and 9B are compared, the gap between adjacent solar battery cells 1 on a cross-section is changed from G to G' in accordance with the rotation angle φ of the light reuse sheet 12.

Namely, the gap which is visible between mutually adjacent solar battery cells 1 increases in accordance with the rotation angle φ of the light reuse sheet 12, and there is an increased possibility of improving the efficiency of the light reuse sheet 12.

In contrast, because the solar battery cells 1 have horizontal and vertical lengths, there is a concern that it may not be possible to cause light reflected onto the light reuse sheet 12 to be incident once again onto the solar battery cells 1.

Because of this, a proportion of the surface area onto which light can be incident again is determined below using a numerical formula, and the optimum conditions are then determined by evaluating the results thereof.

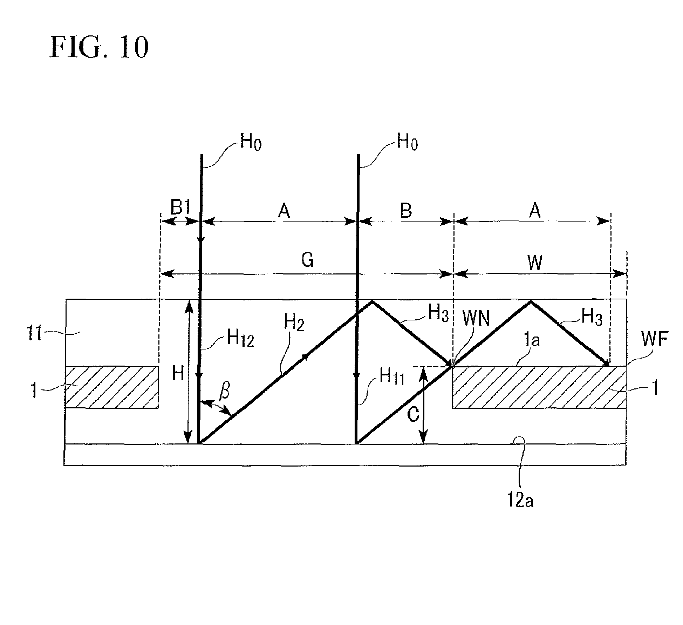

FIG. 10 shows an example in which the gap G between adjacent solar battery cells 1 has been sufficiently widened so that the efficiency of the light reuse sheet 12 is at maximum.

Namely, mutually adjacent solar battery cells 1 are positioned so that they do not interfere with the area where light can be reused.

In FIG. 10, the reflection light H2 from the light H11 which is incident to a boundary between the area A and the area B is incident between an end portion WN on the incidence light H11 side of the light receiving surface 1a and an end portion WF on the incidence light H11 side of the light receiving surface 1a. Here, on the area A, the reflection light H2 is incident to the light receiving surface 1a of the solar battery cells 1. Also, on the area B, the reflection light H2 is not incident to the light receiving surface 1a of the solar battery cell 1 which is on the solar battery cell 1 side where the reflection light H2 is incident.

Moreover, the reflection light H2 from the light H12 which is incident to a boundary with the area B is incident to an end portion WN on the incidence light H11 side of the light receiving surface 1a. Here, on the area B, the reflection light H2 is not incident to the light receiving surface 1a of the solar battery cell 1 which is on the opposite side of the solar battery cell 1 from the side where the reflection light H2 is incident.

The conditions for there to be no interference with the areas where light can be reused between mutually adjacent solar battery cells 1 are expressed by the following Equations (8) and (9).

$$\text{(Formula 14)} \qquad A + B \le G \cdots (8)$$

$$\text{(Formula 15)} \qquad A \le Lx, Ly \cdots (9)$$

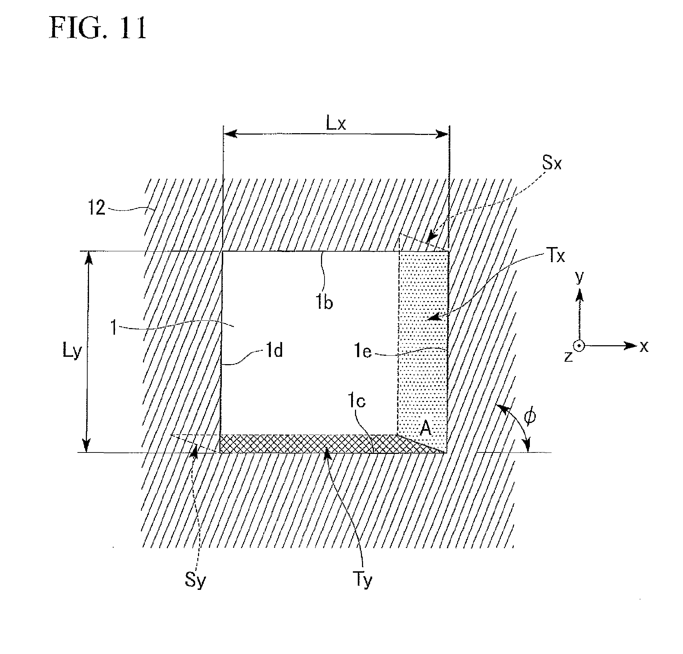

FIG. 11 shows a state of the rotation angle φ of the light reuse sheet 12 when the gap G between adjacent solar battery cells 1 is determined using the conditions in Equations (8) and (9).

At this time, the rotation angle φ satisfies the conditions of Equation (7).

Furthermore, the solar battery cell 1 has the length Lx in the horizontal direction (i.e., the x direction) and the length Ly in the vertical direction (i.e., the y direction).

As shown in FIG. 10, an area where light can be reused in the solar battery cell 1 is shown by the reference numeral A in FIG. 11.

The distance of A is a distance that takes a side surface of the solar battery cell 1 as its base point.

As shown in FIG. 11, the distance of A is a distance in a vertical direction from the rotation angle φ of the light reuse sheet 12.

Moreover, because the light reuse sheet 12 is present, reuse light can be incident to the light receiving surface 1a from the four side surfaces of the solar battery cell 1.

In FIG. 11, only the reuse areas of the side surfaces 1e and 1c of the solar battery cell 1 are shown, and the light reuse area in a horizontal direction from the vertical direction side surface 1e is shown as Sx, while the light reuse area in a vertical direction from the horizontal direction side surface 1c is shown as Sy.

However, in these light reuse areas Sx and Sy, reflected light H2 cannot be incident to the solar battery cell 1.

The areas where light can actually be incident are the intersection faces between these light reuse areas Sx and Sy and the solar battery cell 1.

In FIG. 11, the reuse area of the light incident to the light receiving surface 1a from the vertical direction side surface 1e of the solar battery cell 1 is represented as Tx, while the reuse area of the light incident to the light receiving surface 1a from the horizontal direction side surface 1a of the solar battery cell 1 is represented as Ty.

Tx and Ty are expressed by Equations (10) and (11).

$$\text{(Formula 16)} \qquad Tx(\phi) = A \cdot Ly \cdot \sin\phi - \frac{A^2 \cdot \cos\phi \cdot \sin\phi}{2} \cdots (10)$$

(Formula 17)

$$Ty(\phi) = A \cdot Lx \cdot \cos\phi - \frac{A^2 \cdot \cos\phi \cdot \sin\phi}{2} \cdots (11)$$

Furthermore, if the area of light that can be incident to the solar battery cell 1 from the four side surfaces and reused is represented as f, then the following Equation (12) applies.

(Formula 18)

$$f(\phi) = 2 \cdot [Tx(\phi) + Ty(\phi)] \cdots (12)$$

From Equations (10) and (11), the area f can be expressed by Equation (13).

(Formula 19)

$$f(\phi) = 2 \cdot A \cdot (Lx \cdot \cos\phi + Ly \cdot \sin\phi - A \cdot \sin\phi \cdot \cos\phi) \cdots (13)$$

If it is necessary to ascertain the optimum rotation angle φ of the maximum reusable light area, then Equation (14) which is determined from Equation (13) can be used.

(Formula 20)

$$\frac{df}{d\phi} = 0 = Ly \cdot \cos\phi - Lx \cdot \sin\phi - A(\cos^2\phi - \sin^2\phi) \cdots (14)$$

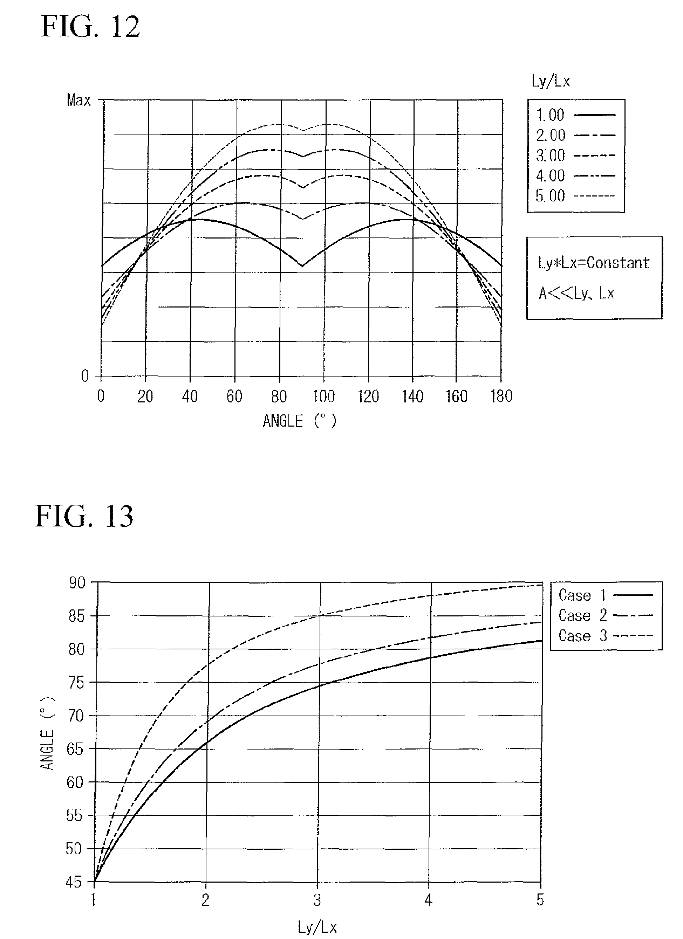

FIG. 12 shows the area f which is calculated from Equation (13).
In this calculation, Equations (7), (8), and (9) are used.
Moreover, although the surface area (Lx x Ly) of the solar cell is fixed, the results when Lx/Ly was changed in order to compare the effects obtained from various shapes of the solar cell 1 (i.e., the effect of a square shape or of a rectangular shape) are also shown.
In the case of a square solar battery cell 1, the area f reaches maximum value when the rotation angle φ is at 45°.
If the rotation angle φ is smaller than 45°, the area f also becomes smaller, while if it is 0°, f reaches minimum value.
In the same way, if the rotation angle φ is greater than 45°, the area f again becomes smaller, while if it is 90°, f again reaches minimum value.
Additionally, when the rotation angle φ is 90° and when it is 0°, the numerical value of f is the same.
This result is also obtained from Equation (14).
At this time, a square solar battery cell 1 is shown by Equation (15).

(Formula 21)

$$Lx = Ly = L \cdots (15)$$

Additionally, the conditions of A are shown only by Equation (9) and it is necessary for Equation (16) to be established in various A.

(Formula 22)

$$0 = L \cdot (\cos\phi - \sin\phi) - A(\cos^2\phi - \sin^2\phi) \cdots (16)$$

Because of this, Equation (17) is established which results in Equation (18) being obtained.

(Formula 23)

$$\sin\phi = \cos\phi \cdots (17)$$

(Formula 24)

$$\phi = 45° \cdots (18)$$

In contrast, in the case of a rectangular solar battery cell 1, a simulation was performed in order to find at what rotation angle φ the area f was at the maximum value.

In the simulation, a condition was set where the length in the vertical direction Ly of the solar battery cell 1 was longer than the length in the horizontal direction Lx thereof, and the results when Ly/Lx was plotted from 2 to 5 are shown in FIG. 12.

From this graph, 45° is no longer where the area f is at the maximum value.

Moreover, it is also clear that, as the ratio of Ly/Lx increases, the optimum rotation angle approaches 90°.

Furthermore, it is also clear that, as the ratio Ly/Lx increases, the maximum area f gradually increases.

Namely, in order to obtain the maximum reuse light, it was confirmed that it is preferable for the solar battery cell 1 to be rectangular rather than square, and that a longer long side relative to the length of the short side is better.

For example, from FIG. 12, when Ly/Ly is 1, the optimum rotation angle φ is in the vicinity of 45°. If for this case the area f is set to 1.0, then when Ly/Ly is 2, the optimum rotation angle φ is in the vicinity of 60°, the area f is 1.1. When Ly/Ly is 3, the optimum rotation angle φ is in the vicinity of 70° and the area f is 1.3.

Since it is not necessary to consider the gaps G between solar battery cells 1, the maximum value of the area A to which reflection light is incident to the light receiving surface 1a can be easily calculated.

Equation (19) is determined from FIG. 10 from a height H from the front surface 200a of the solar cell to the light reuse sheet 12, and a spacing C from the reflective surface 12a of the light reuse sheet 12 to the light receiving surface 1a of the solar battery cell 1, and the angle β between the incidence light H0 and the reflected light H2.

(Formula 25)

$$A_{Max} = 2(H - C) \cdot \tan\beta \cdots (19)$$

From Equation (19), it is seen that the only way to increase an area Amax onto which the reflected light H2 is incident to the light receiving surface 1a is to either increase H, or reduce C, or increase β.

On the other hand, if the prism angle is made larger in order to increase β, as the prism angle becomes larger, the light which is reflected onto one prism strikes the adjacent prism, and the angle of the light rays changes, as a result, there is a concern that the overall reflection conditions is nullified.

In order to prevent the foregoing interference, it is necessary to limit the range of the angle β to between approximately 60° and 40°.

If this mode is employed, then, for example, in the structure of a solar cell, (H-C) is approximately 5 mm, β is approximately 60°, and Amax is approximately 17 mm.

If the size of a normal solar battery cell 1 is considered, then Equations (7) to (14) can be appropriately applied.

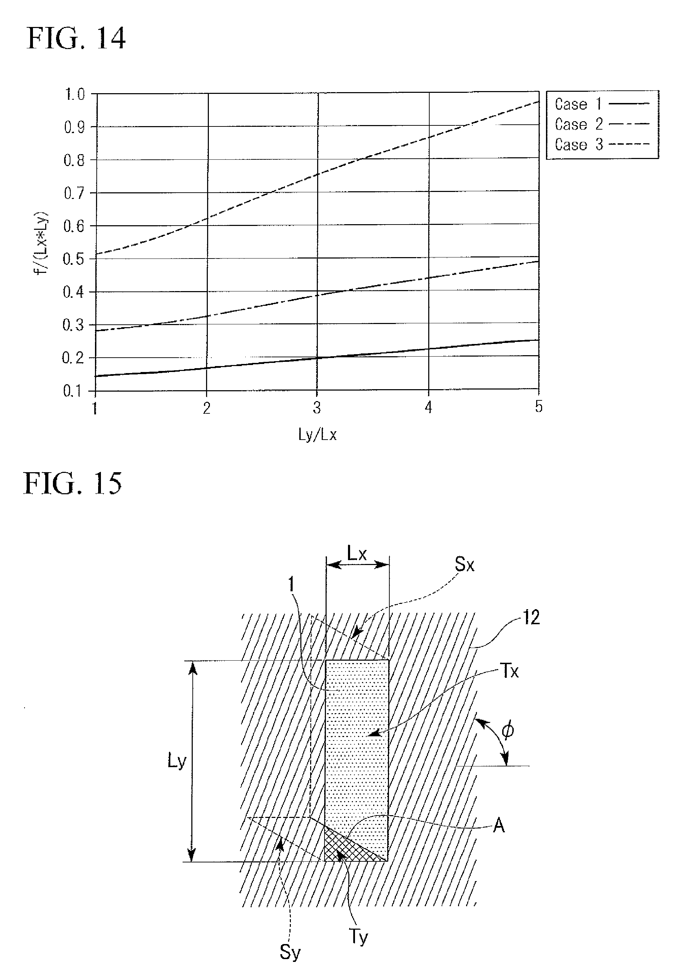

FIGS. 13 and 14 show the results when the optimum rotation angle φ and reuse area f were compared for three different sizes of a typical solar battery cell 1 (i.e., when the widths of a square solar battery cell 1 were 156 mm (Case 1), 78 mm (Case 2), and 39 mm (Case 3)) with Amax being set at 17 mm.

In FIG. 13, in the same way as described above, when the shape of the solar battery cell 1 was set as a rectangular shape, the optimum rotation angle φ is changed from 45° through 90°.

Moreover, the smaller the solar battery cell 1, the sooner the change occurred.

For example, when Ly/Lx was 3, the optimum rotation angle φ was 75°, 78°, and 85° respectively for Case 1, Case 2, and Case 3.

In FIG. 14, in the same way as described above, when the shape of the solar battery cell 1 was set as a rectangular shape, the reuse area f becames larger.

Furthermore, if the reuse areas f are compared in units of surface area, it is seen that the effect obtained in Case 3 is superior to that obtained in Case 1.

The description has hitherto been made using Equations (7), (8), and (9), however, if the conditions of Equation (9) in particular cannot be applied, restrictions occur on the area of reuse light of the solar battery cell 1.

In contrast to this, FIG. 15 shows the result when the conditions of Equation (9) are disturbed by the rotation angle φ of the light reuse sheet 12.

In the same way as in FIG. 12, as the rotation angle φ becomes larger from 0°, the area f also becomes larger.

In contrast, if the rotation angle φ satisfies the conditions of Equation (20), there is no change in the area f and it remains constant.

Namely, the conditions of Equation (20) are not affected by the rotation angle φ, and this fact was confirmed by FIG. 12.

(Formula 26)

$$90 \geq \phi \geq \sin^{-1}(Lx/A) \cdots (20)$$

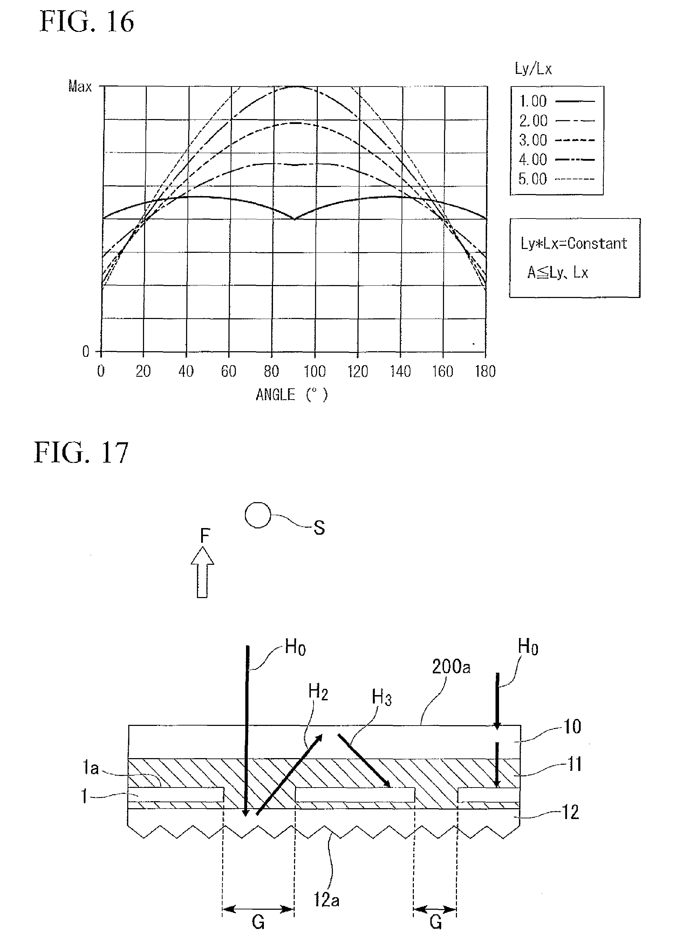

In FIG. 16, an area f which was calculated by including the conditions of Equation (20) is shown.

The surface area (Lx x Ly) of the solar cell is fixed, and the effects are shown when the shape of the solar battery cell 1 was changed from a square to a rectangle.

When Lx/Ly changes from 1 to 4, the conditions of Equations (7), (8), and (9) are satisfied, and are the same as in FIG. 12.

In contrast, when Lx/Ly is 5, an area (Equation (20)) where all of the rotation angle areas (Equations (7), (8), and (9)) are disturbed appears.

In addition, the reuse area f is at the maximum value and even if the rotation angle φ is changed, f does not change and, in FIG. 16, the rotation angle φ in this area is in a range of approximately 65° to 90°.

According to a solar battery module 200 which uses the light reuse sheet 12 having the above-described structure, light which is incident to the areas G between mutually adjacent solar battery cells 1 is reflected by the reflective surface 12a of the light reuse sheet 12 and the light is incident to the solar battery cells 1.

As a result of this, it is possible to use this light that is incident to the areas G between mutually adjacent solar battery cells 1, and the power generation efficiency of the solar battery module 200 can be improved.

In contrast, as shown in FIG. 17, even if the rear surface of the reflective surface 12a of the light reuse sheet 12 is positioned so as to face toward the packing layer 11 side, it is possible to obtain the same effects from the light reuse sheet 12 as those described above.

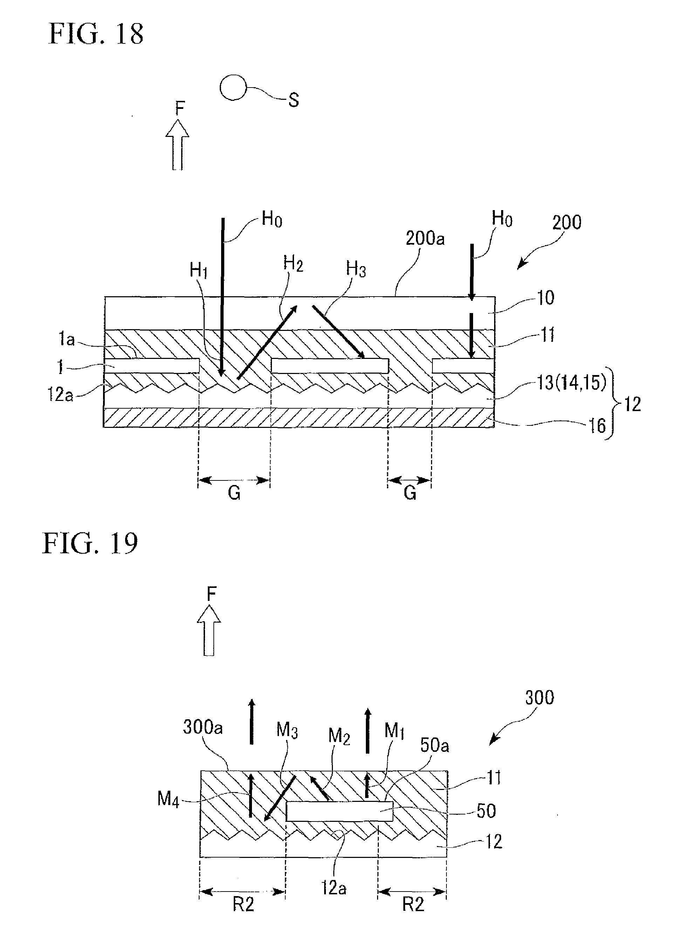

Moreover, as shown in FIG. 18, it is also possible to use a structure in which this light reuse sheet 12 includes a barrier layer 16 made of either an aluminum layer having a thickness of 10 μm to 30 μm, or a silica layer having a thickness of 10 nm to 100 nm.

Furthermore, in order to increase durability, it is also possible to protect the solar battery module 200 by coating PVF (polyvinyl fluoride resin) thereon, or by adhering thereon a film having polyvinyl fluoride resin.

By employing this type of structure, the barrier layer 16 can also be used as a backing sheet for the solar battery module 200.

Examples

Here, the predominance of the light reuse sheet 12 and the solar battery module 200 which uses it of the present invention will be specifically described.

(Example 1)

In Example 1, a PET film having a thickness of 250 μm was used for the base 15.

For the structural layer 13, a layer in which a triangular prism-shaped uneven configuration having a pitch of 150 μm and a reflective surface apex angle of 135° was formed from an ultraviolet curable acrylic resin was stacked on a PET film, and for the metallic reflective layer 14, an aluminum layer having a thickness of 100 nm was formed by vapor-deposition so as to form a light reuse sheet 12.

A solar battery module 200 was then manufactured using a light reuse sheet 12 which was manufactured in this manner.

A glass plate having a thickness of approximately 3 mm was used for the front-surface plate 10, and a packing layer 11 having a thickness of approximately 0.5 mm was formed thereon by filling EVA so that the solar battery cells 1 were positioned 0.5 mm from the front-surface plate 10.

Polycrystalline silicon solar cells formed in a square shape having a length of 150 mm and a thickness of 0.2 mm were used for the solar battery cells 1, and the above-described light reuse sheet 12 having a width of approximately 25 mm was placed around the periphery of the solar battery cells 1 at a position of 0.5 mm from the light receiving surface 1a of the solar battery cells 1.

At this time, the light reuse sheet 12 was positioned such that the direction of the triangular prism-shaped irregularity was parallel with the end portions of the solar battery cells 1.

The results obtained when the power generation efficiency of the solar battery module 200 of Example 1 was measured are shown in Table 1.

(Example 2)

Next, in Example 2, a PET film having a thickness of 250 $\mu$m was used for the base 15.

For the structural layer 13, a layer in which a triangular prism-shaped uneven configuration having a pitch of 200 $\mu$m and a reflective surface apex angle of 120° was formed from an ultraviolet curable acrylic resin was stacked on a PET film, and for the metallic reflective layer 14, an aluminum layer having a thickness of 100 nm was formed by vapor-deposition so as to form a light reuse sheet 12.

A solar battery module 200 was then manufactured using a light reuse sheet 12 which was manufactured in this manner.

A glass plate having a thickness of approximately 3 mm was used for the front-surface plate 10, and a packing layer 11 having a thickness of approximately 0.5 mm was formed thereon by filling EVA so that the solar battery cells 1 were positioned 0.5 mm from the front-surface plate 10.

Polycrystalline silicon solar cells formed in a square shape having a length of 150 mm and a thickness of 0.2 mm were used for the solar battery cells 1, and the above-described light reuse sheet 12 having a width of approximately 25 mm was placed around the periphery of the solar battery cells 1 at a position of 0.5 mm from the light receiving surface 1a of the solar battery cells 1.

At this time, the light reuse sheet 12 was positioned such that the direction of the triangular prism-shaped irregularity was parallel with the end portions of the solar battery cells 1.

The results obtained when the power generation efficiency of the solar battery module 200 of Example 2 was measured are also shown in Table 1.

(Example 3)

Next, in Example 3, a PET film having a thickness of 250 $\mu$m was used for the base 15.

For the structural layer 13, a layer in which a triangular prism-shaped uneven configuration having a pitch of 150 $\mu$m and a reflective surface apex angle of 135° was formed from an ultraviolet curable acrylic resin was stacked on a PET film, and for the metallic reflective layer 14, an aluminum layer having a thickness of 100 nm was formed by vapor-deposition so as to form a light reuse sheet 12.

A solar battery module 200 was then manufactured using a light reuse sheet 12 which was manufactured in this manner.

A glass plate having a thickness of approximately 3 mm was used for the front-surface plate 10, and a packing layer 11 having a thickness of approximately 0.5 mm was formed thereon by filling EVA so that the solar battery cells 1 were positioned 0.5 mm from the front-surface plate 10.

Polycrystalline silicon solar cells formed in a square shape having a length of 150 mm and a thickness of 0.2 mm were used for the solar battery cells 1, and the above-described light reuse sheet 12 having a width of approximately 25 mm was placed around the periphery of the solar battery cells 1 at a position of 0.5 mm from the light receiving surface 1a of the solar battery cells 1.

At this time, the light reuse sheet 12 was positioned such that the direction of the triangular prism-shaped irregularity was inclined at 45° relative to the end portions of the solar battery cells 1.

The results obtained when the power generation efficiency of the solar battery module 200 of Example 3 was measured are also shown in Table 1.

(Example 4)

Next, in Example 4, a PET film having a thickness of 250 μm was used for the base 15.

For the structural layer 13, a layer in which a triangular prism-shaped uneven configuration having a pitch of 200 μm and a reflective surface apex angle of 120° was formed from an ultraviolet curable acrylic resin was stacked on a PET film, and for the metallic reflective layer 14, an aluminum layer having a thickness of 100 nm was formed by vapor-deposition so as to form a light reuse sheet 12.

A solar battery module 200 was then manufactured using a light reuse sheet 12 which was manufactured in this manner.

A glass plate having a thickness of approximately 3 mm was used for the front-surface plate 10, and a packing layer 11 having a thickness of approximately 0.5 mm was formed thereon by filling EVA so that the solar battery cells 1 were positioned 0.5 mm from the front-surface plate 10.

Polycrystalline silicon solar cells formed in a square shape having a length of 150 mm and a thickness of 0.2 mm were used for the solar battery cells 1, and the above-described light reuse sheet 12 having a width of approximately 25 mm was placed around the periphery of the solar battery cells 1 at a position of 0.5 mm from the light receiving surface 1a of the solar battery cells 1.

At this time, the light reuse sheet was positioned such that the direction of the triangular prism-shaped irregularity was inclined at 45° relative to the end portions of the solar battery cells 1.

The results obtained when the power generation efficiency of the solar battery module 200 of Example 3 was measured are also shown in Table 1.

In contrast, in Comparative example 1 a PET film having a thickness of 250 μm was used for the base 15.

Without forming the structural layer 13, an aluminum layer having a thickness of 100 nm was formed by vapor-deposition for the metallic reflective layer 14 so as to obtain a light reuse sheet.

A solar battery module was then manufactured using a light reuse sheet which was manufactured in this manner.

A glass plate having a thickness of approximately 3 mm was used for the front-surface plate 10, and a packing layer 11 having a thickness of approximately 0.5 mm was formed thereon by filling EVA so that the solar battery cells 1 were positioned 0.5 mm from the front-surface plate 10.

Polycrystalline silicon solar cells formed in a square shape having a length of 150 mm and a thickness of 0.2 mm were used for the solar battery cells 1, and the above-described light reuse sheet having a width of approximately 25 mm was placed around the periphery of the solar battery cells 1 at a position of 0.5 mm from the light receiving surface 1a of the solar battery cells 1.

The results obtained when the power generation efficiency of the solar battery module of Comparative example 1 was measured are also shown in Table 1.

(Table 1)

|  | RELATIVE POWER GENERATION EFFICIENCY |
|---|---|
| EXAMPLE 1 | 110. 9% |
| EXAMPLE 2 | 112. 7% |
| EXAMPLE 3 | 113. 0% |
| EXAMPLE 4 | 114. 5% |
| COMPARATIVE EXAMPLE 1 | 100. 0% |

As shown in Table 1, if the power generation efficiency of Comparative example 1 is 100.0%, then power generation efficiencies of 110.9% in Example 1, 112.7% in Example 2, 113.0% in Example 3, and 114.5% in Example 4 were achieved. It was thus proved that, relative to Comparative example 1, a higher power generation efficiency was achieved in all four cases of Examples 1 to 4 in which the light reuse sheet 12 of the present invention was provided.

A first embodiment of the light reuse sheet and solar battery module that uses this light reuse sheet according to the present invention is described above, however, the present invention is not limited to the above-described first embodiment, and various modifications may be made insofar as they do not depart from the scope of the present invention.

For example, it is not necessary for the light reuse sheet 12 of the present invention to be limited to being applied to the solar battery module 200 and, as shown in FIG. 19, it can also be used for reusing light from a light emitting element such as an LED or EL or the like.

Specifically, FIG. 19 is a cross-sectional view showing an embodiment of a light source module 300 according to the present invention.

This light source module 300 is formed by a packing layer 11, a light emitting element 50, and a light reuse sheet 12.

In addition, the light emitting element 50 has a function of converting electricity into light by electroluminescence, and emits this light from a light emitting surface 50a.

Moreover, a solid light emitting diode such as an LED, organic EL, inorganic EL, or the like is preferably used for the light emitting element 50.

The packing layer 11 is a layer which seals the light emitting element 50.

Light M1 and M2 which are emitted from the light emitting element 50 pass through the packing layer 11 and a portion thereof become light M1 which is emitted from an emission surface 300a, while the remainder becomes light M2 which is reflected by an emission surface 30a.

A material having a high light transmittance in order to transmit light incident to the packing layer 11 is used for the packing layer 11, and an acrylic resin or the like having a high transmittance is preferably used.

The portion M2 of the light emitted from the light emitting element 50 is reflected by the emission surface 300a and is incident to the reflective surface 12a of the light reuse sheet 12.

Light M3 which is incident to the reflective surface 12a is reflected in a specific direction by the reflective surface 12a, and becomes once again incident to the emission surface 300a. It then becomes light M4 which is emitted to the outside via the emission surface 300a.

As a result, compared with a structure in which there is no light reuse sheet 12, the effect is obtained that the light utilization efficiency can be improved.

On the other hand, the effect obtained from the light reuse sheet 12 is only evident when the relationship between the lengths and placement of the light emitting element 50 and light reuse sheet 12 and the angle β between the reflected light M4 and the light M3 which is incident to the reflective surface 12a is within a suitable range. This relationship preferably satisfies Equation (1), and more preferably also satisfies Equations (2) and (3), and still more preferably also satisfies Equation (4), and even more preferably also satisfies Equation (4).

Second embodiment

In the second embodiment described below, component elements that are the same as those in the above-described first embodiment are given the same descriptive symbols and any description thereof is either omitted or simplified.

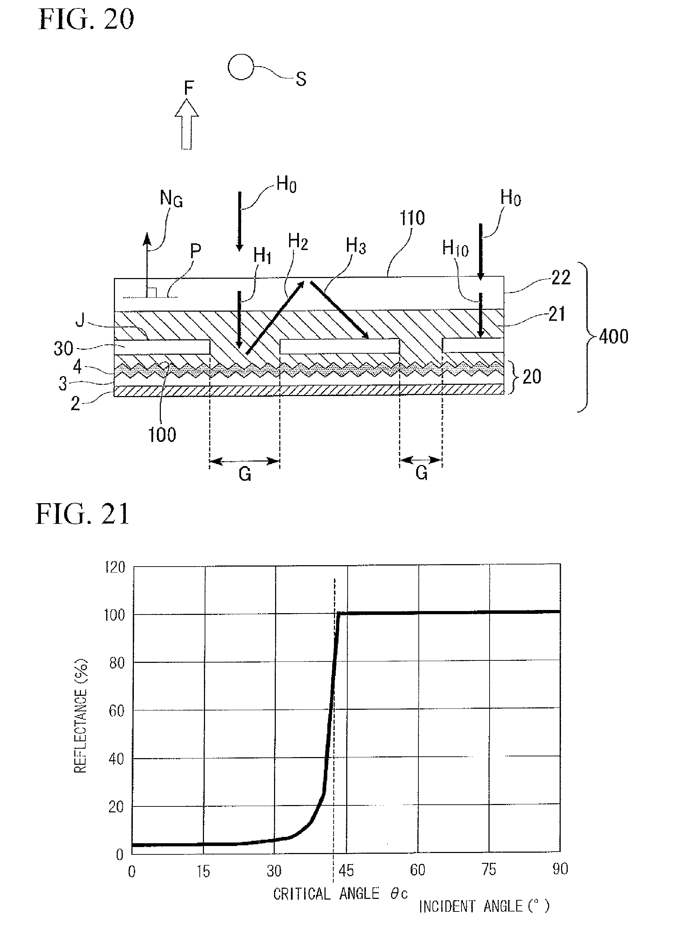

FIG. 20 is a cross-sectional view showing an embodiment of a solar battery module 400 of the present invention.

The solar battery module 400 of the present invention includes a front-surface plate 22, a packing layer 21, and a light reuse sheet 20.

The front-surface plate 22 protects solar battery cells 30 from impact, contamination, water ingress, and the like while allowing light from a light source S such as sunlight or illumination light to pass through, and is formed from a transparent material having a high light transmittance.

As a result of this, light H0 which is created when light from the light source S is perpendicularly incident to an incident surface 110 from the side F of the sunlight or illumination light is incident to the front-surface plate 22 and passes through this front-surface plate 22, and is emitted into the packing layer 21.

Additionally, a normal line NG of the incident surface 110 extends in a direction which is parallel to a normal line of a plane P when the front-surface plate 22 has been placed horizontally on the plane P.

The light which is perpendicularly incident to the incident surface 110 is light which is incident to the solar battery module 400 in parallel with this normal line NG.

Moreover, the material used to form the front-surface plate 22 is glass such as toughened glass or sapphire glass, or a resin sheet such as PC (polycarbonate) or PEN (polyethylene naphthalate).

Furthermore, if the front-surface plate 22 is toughened glass, the thickness of the front-surface plate 22 is set to approximately 3 to 6 mm.

If the front-surface plate 22 is a resin sheet the thickness of the front-surface plate 22 is set to approximately 100 $\mu$m to 3000 $\mu$m.

The light emitted from the front-surface plate 22 is incident to the packing layer 21.

The packing layer 21 is a layer which seals the solar battery cells 30.

The light H0 which is incident to the front-surface plate 22 is transmitted through the packing layer 21 and forms light H10 that is emitted toward the solar battery cells 30. Part of this light then becomes light H1 that is emitted onto the light reuse sheet 20.

A material having a high light transmittance is used in order to allow the incidence light H0 to pass through the packing layer 21 and EVA (ethylene vinyl acetate) having flame-resistant is widely used.

The solar battery cells 30 have a function of converting light which is incident to a light receiving surface J into electricity by photoelectric effect.

A large number of different types of solar battery cells are used such as single-crystalline silicon solar batteries, polycrystalline silicon solar batteries, thin-film silicon solar batteries, and compound thin-film solar batteries such as CdTe (Cd-Te compound) based solar batteries and CIGS (Cu-In-Ga-Se compound) based solar batteries.

A usable module is formed by connecting together a plurality of these solar battery cells 30 via electrodes.

The light H10 which is incident to the solar battery cells 30 from the packing layer 21 is converted into electricity in these solar battery cells 30.

Normally, a greater proportion of the light which is incident diagonally onto the incident surface 110 is reflected by the incident surface 110 compared with the light H0 which is incident perpendicularly thereon, and a smaller quantity of this light is incident directly onto the solar battery cells 30 so that the quantity of light that can be used for power generation is reduced.

Because of this, when the incidence light H0 is incident substantially perpendicularly onto the incident surface 110, the efficiency it is at its highest.

The light reuse sheet 20 has the function of reflecting light which has passed through the solar battery cells 30 themselves, and the light H1 which is incident between solar battery cells 30 by a reflective surface 100.

The reflected light H2 is once again reflected by the boundary face between the front-surface plate 22 and the external atmosphere and the like so as to become light H3 which is incident to the light receiving surfaces J of the solar battery cells 30 and is photoelectrically converted.

As a result of this, compared with a structure in which there is no light reuse sheet 20, the effect is obtained that the light utilization efficiency is improved.

The direction in which the reflection light H2 travels can be controlled by the uneven structure of the reflective surface 100 of the present invention, and a considerable quantity of the light can be incident to the light receiving surfaces J.

The uneven structure of the reflective surface 100 will be described using a normal line N0 thereof.

At any point on the reflective surface 100, the normal line N0 of the reflective surface 100 is a straight line which is a vertical plane relative to a tangential plane at that any point.

A sheet normal line NB is a direction which is parallel with a normal line N of a plane P when the light reuse sheet 20 has been stably placed on the plane P.

Moreover, an angle θ of the reflective surface 100 is an angle of intersection between the normal line N0 of the reflective surface 100 and the sheet normal line NB.

Normally, because the sheet normal line NB is positioned so as to be parallel with the normal line NG of the incident surface 110, the incidence light H1 is incident in parallel with the sheet normal line NB.

The reflectance of the reflection light H2 changes greatly depending on the angle of incidence thereof onto the incident surface 110.

FIG. 21 shows changes in reflectance caused by the angle of incidence.

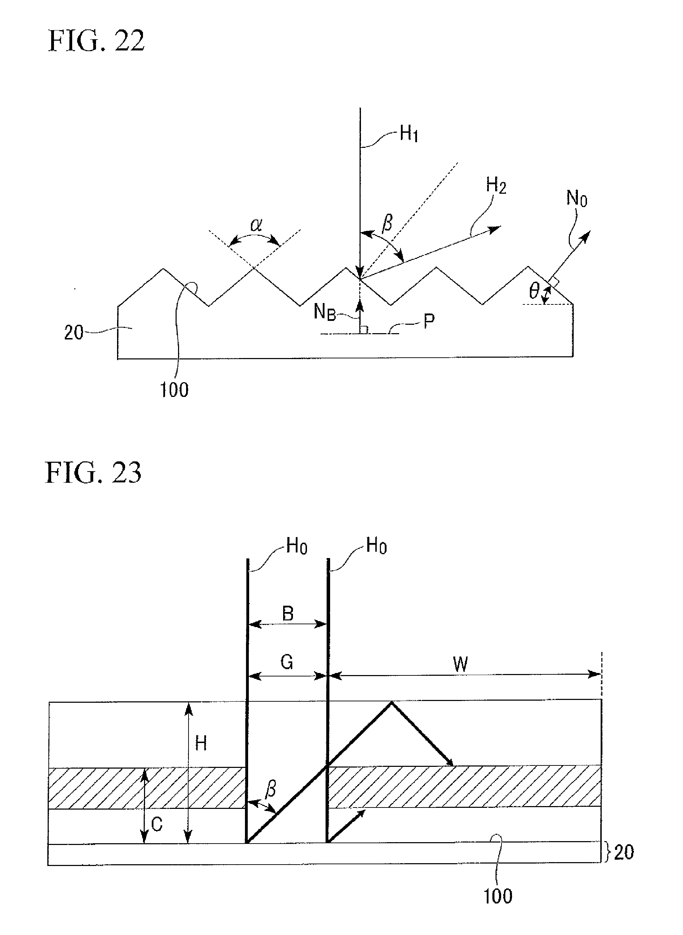

As seen from FIG. 22, it is also known that the reflectance changes considerably taking the critical angle θc as a boundary.

If the reflectance of the front-surface plate 22 is represented as ng, this critical angle θc is expressed as

(Formula 27)

$$\theta_C = \arcsin(1/ng) \cdots (21)$$

At an angle greater than this critical angle θc, all of the light H2 which is incident to the incident surface 110 is reflected by the incident surface 110.

Moreover, if ne is the refractive index of the packing layer 21, and θ2 is the angle of the reflection light H2 relative to the normal line NG, then by Snell's law,

(Formula 28)

$$ng \cdot \sin\theta_C = ne \cdot \sin\theta_2 \cdots (22)$$

From Equations (21) and (22)

(Formula 29)

$$\theta_2 = \arcsin(1/ne)\cdots(23)$$

is established.

Additionally, when the packing layer is made up of a plurality of layers, if n0 is the refractive index of the material on the top of the reflective surface, then in the same way,

(Formula 30)

$$\theta_2 = \arcsin(1/no)\cdots(24)$$

is established.

If the angle of the reflective surface 100 is 0, then this θ2 is found by.

(Formula 31)

$$\theta_2 = 2\cdot\theta\cdots(25)$$

is established.

From the above, if the angle θ of the reflective surface 100 is expressed by

(Formula 32)

$$2\cdot\theta \geq \arcsin(1/no)\cdots(26)$$

then all of the reflection light H2 is reflected onto the front-surface plate.

As described above, the light reuse sheet 20 has a function of reflecting the light H1 that is incicent between the solar battery cells 30 by the reflective surface 100.

The reflected light H2 is once again reflected by the boundary face between the front-surface plate 22 and the external atmosphere and the like so as to become the light H3 which is incident to the light receiving surfaces J of the solar battery cells 30 and is photoelectrically converted.

As a result of this, compared with a structure in which there is no light reuse sheet 20, the effect is obtained that the light utilization efficiency is improved.

However, the effect obtained from the light reuse sheet 20 is only evident when the relationship between the lengths and placement of the solar battery cells 30 and light reuse sheet 20 and the angle β between the incidence light H1 and the emission light H2 is within a suitable range.

Hereinafter, a description will be given of each separate instance shown in FIGS. 23 to 28 using as the lengths and placement of the above-described solar battery cells 30 and light reuse sheet 20, the gap G between the solar battery cells 30, the intervals H between the incident surface 110 of the solar battery module 400 and the reflective surface 100 of the light reuse sheet 20, and the width W of the solar cells.

Additionally, in FIGS. 23 to 28, because the description concerns relationships between the lengths, the placement, and the angle β between the incidence light H1 and the emission light H2, the uneven configuration of the reflective surface 100 of the light reuse sheet 20 is not shown in the drawings.

In FIG. 23, because the light H2 which is reflected in the gaps G between the solar battery cells 30 is not incident once again onto the incident surface 110, the light H2 which is reflected by the light reuse sheet 20 is not incident to the light receiving surface J.

A conditional formula for this is as follows:

(Formula 33) $$G \leq C \cdot \tan\beta \cdots (27)$$

At this time, the length L of an area B where the reflection light H2 from among the light H1 which is incident to the gaps G between the solar battery cells 30 is not incident is found by

(Formula 34) $$L = G \cdots (28)$$

Additionally, because the light which is not incident to the area B is not incident to the light receiving surface J, it becomes unused lost light.

Because of this, the larger the size of L, the greater the amount of lost light and, conversely, the smaller the size of L, the lesser the amount of lost light.

If L = G, there is no light which is reflected by the reflective surface 100 of the light reuse sheet 20 and is incident to the light receiving surface J.

In this case, the light H1 which is incident into the gaps G between the solar battery cells 30 is not preferable since it is not used.

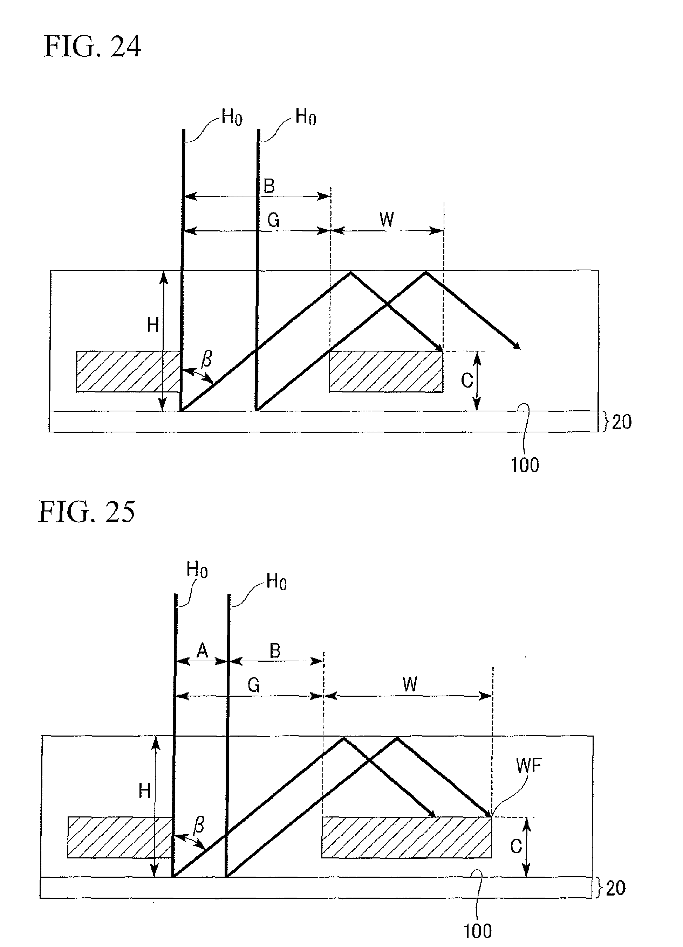

In the same way as in FIG. 23, FIG. 24 shows a case in which the length L of the area B is G.

In FIG. 24, a portion of the light H2 which is reflected in the gaps G between the solar battery cells 30 is incident to the incident surface 110, however, because it is not incident to the light receiving surface J of the solar battery cells 30 but is incident as it is once again onto the light reuse sheet 20, in the same way as in the case shown in FIG. 23, the length L of the area B equals G.

If the following conditional formula is established,

(Formula 35)

$$C \cdot \tan\beta \leq G \leq (2H - C) \cdot \tan\beta \leq G + W \cdots (29)$$

then light does enter the solar battery cells, however, in all other cases, the light H1 which is incident into the gaps G between the solar battery cells 30 is not used and is therefore not preferable.

FIG. 25 shows a case in which the width W of the solar battery cells is longer than in the case shown in FIG. 24.

The gaps G between the solar battery cells 30 are divided into an area A where the light H2 reflected by the reflective surface 100 is incident to the light receiving surface J of the solar battery cells 30, and an area B where the light H2 reflected by the reflective surface 100 does not incident to the light receiving surface J of the solar battery cells 30.

Light H11 which, is incident to the boundary between the area A and the area B is incident to an end portion WF of the solar battery cells 30 on the opposite side from the side from where the light H11 is incident.

A conditional formula for this is:

(Formula 36)

$$C \cdot \tan\beta \leq G \leq (2H - C) \cdot \tan\beta \cdots (30)$$

and also

(Formula 37)

$$(2H - C)\tan\beta - G \leq W \leq 2(H - C)\tan\beta \cdots (31)$$

The length L of the area B is

(Formula 38)

$$L = (2H - C) \cdot \tan \beta - W \cdots (32)$$

and this is preferable since the light H1 which is incident into the gaps G between the solar battery cells 30 does become used.

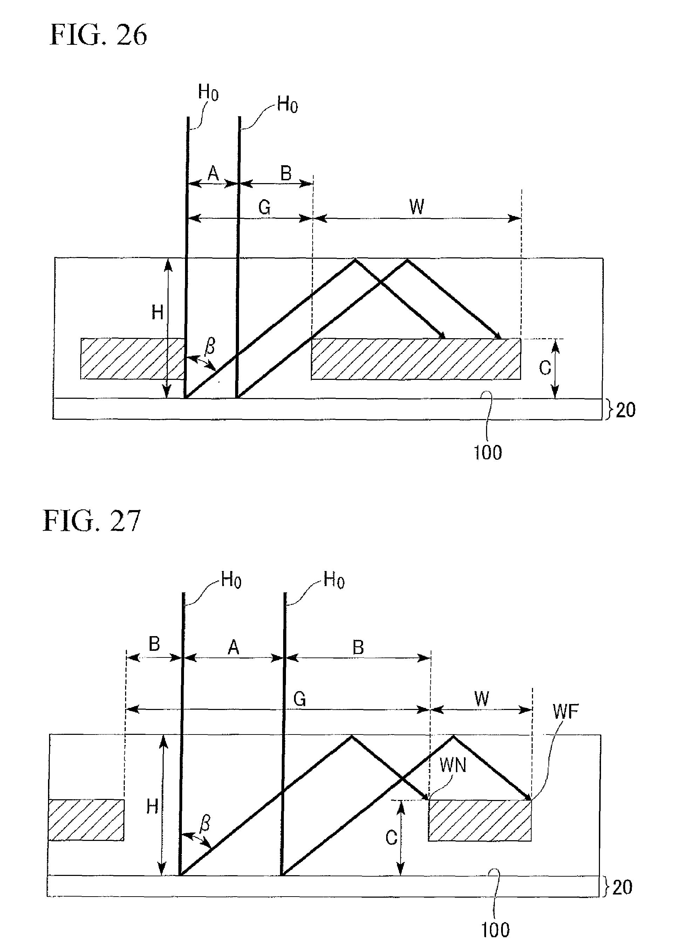

In the case shown in FIG. 26, a portion of the reflection light H2 which is reflected in the gaps G between the solar battery cells 30 is shielded by the solar battery cells 30, while the remainder of the reflection light h2 strikes the light receiving surface J.

A conditional formula for this is:

(Formula 39)

$$C \cdot \tan \beta \le G \le (2H - C) \cdot \tan \beta \cdots (33)$$

and also

(Formula 40)

$$2(H - C) \cdot \tan \beta \le W \cdots (34)$$

The length of the area B is

(Formula 41)

$$L = C \cdot \tan \beta \cdots (35)$$

and this is preferable since the light H1 which is incident into the gaps G between the solar battery cells 30 does become used.

In the case shown in FIG. 27, on the solar battery cell 30 side to which the reflected light H2 is incident, and on the opposite side from the solar battery cell 30 to which the reflection light H2 is incident, there is areas B where the reflection light H2 is not incident to the light receiving surface J of the solar battery cells 30.

The light H11 which is incident to a boundary between the areas A and B is incident to an end portion WF of the light receiving surface J of the solar cell on the opposite side from the light H11 side of the solar battery cells 30. Here, on the area A, the reflection light H2 is incident to the light receiving surface J of the solar battery cells 30. Also, on the area B, the reflection light H2 is not incident to the light receiving surface J of the solar battery cell 30 of the solar battery cell 30 side to which the reflection light H2 is incident.

The light H12 which is incident to a boundary between the areas A and B is incident to an end portion WN of the light receiving surface J of the solar cell on the light H12 side. Here, on the area A, the reflection light H2 is incident to the light receiving surface J of the solar battery cells 30. Also, on the area B, the reflection light H2 is not incident to the light receiving surface J of the solar battery cell 30 which is on the opposite side from the solar battery cell 30 to which the reflection light H2 is incident,

At this time, the width of A is the same length as the width of W.

A conditional formula for this is:

(Formula 42)

$$(2H - C) \cdot \tan \beta \le G \cdots (36)$$

and also

(Formula 43)

$$W \leq 2(H - C) \cdot \tan \beta \cdots (37)$$

The length L of the area B is

(Formula 44)

$$L = G - W \cdots (38)$$

and this is preferable since the light H1 which is incident into the gaps G between the solar battery cells 30 does become used.

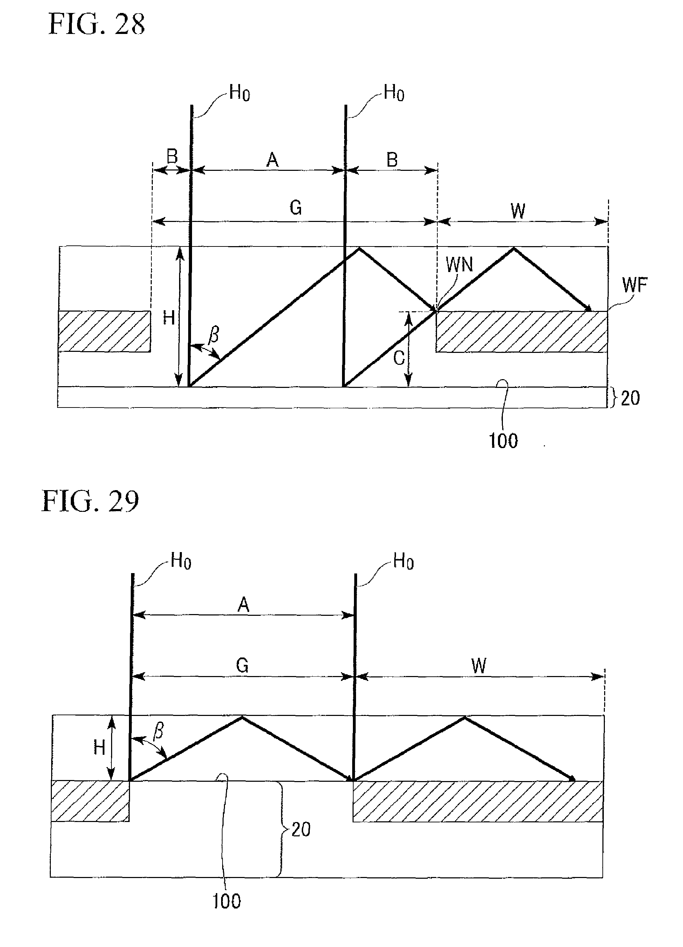

In FIG. 28, the reflection light H2 of the light H1 which is incident to the boundary between the areas A and B is incident between the end portion WN on the incidence light H11 side of the light receiving surface J and the end portion WF on the incidence light H11 side of the light receiving surface J. Here, on the area A, the reflection light H2 is incident to the light receiving surface J of the solar battery cells 30. Also, on the area B, the reflection light H2 is not incident to the light receiving surface J of the solar battery cell 30 which is on the solar battery cell 30 side to which the reflection light H2 is incident.

The reflection light H2 of the light H12 which is incident to the boundary with the area B is incident to the end portion WN on the incidence light H11 side of the light receiving surface J. Here, on the area B, the reflection light H2 is not incident to the light receiving surface J of the solar battery cell 30 which is on the opposite side from the solar battery cell 30 to which the reflection light H2 is incident.

A conditional formula for this is:

(Formula 45)

$$(2H - C) \cdot \tan \beta \leq G \cdots (39)$$

and also

(Formula 46)

$$2(H - C) \cdot \tan \beta \leq W \cdots (40)$$

The length L of the area B is

(Formula 47)

$$L = G - 2(H - C) \cdot \tan \beta \cdots (41)$$

and this is preferable since the light H1 which is incident into the gaps G between the solar battery cells 30 does become used.

In FIG. 29, when the distance C from the reflective surface 100 of the light reuse sheet 20 to the solar battery cell light receiving surface J is 0, and the width W of the solar battery cells 30 is greater than the gaps G between the solar battery cells 30, all of the light which is incident to the light reuse sheet 20 can be incident to the light receiving surface of the solar battery cells.

At this time, the length L of the area B is 0.

A conditional formula for this is:

(Formula 48)

$$C = 0 \cdots (42)$$

and also

(Formula 49)

$$G \leq 2H \cdot \tan\beta \leq W \cdots (43)$$

and light loss can be reduced even further so that this is even more preferable.

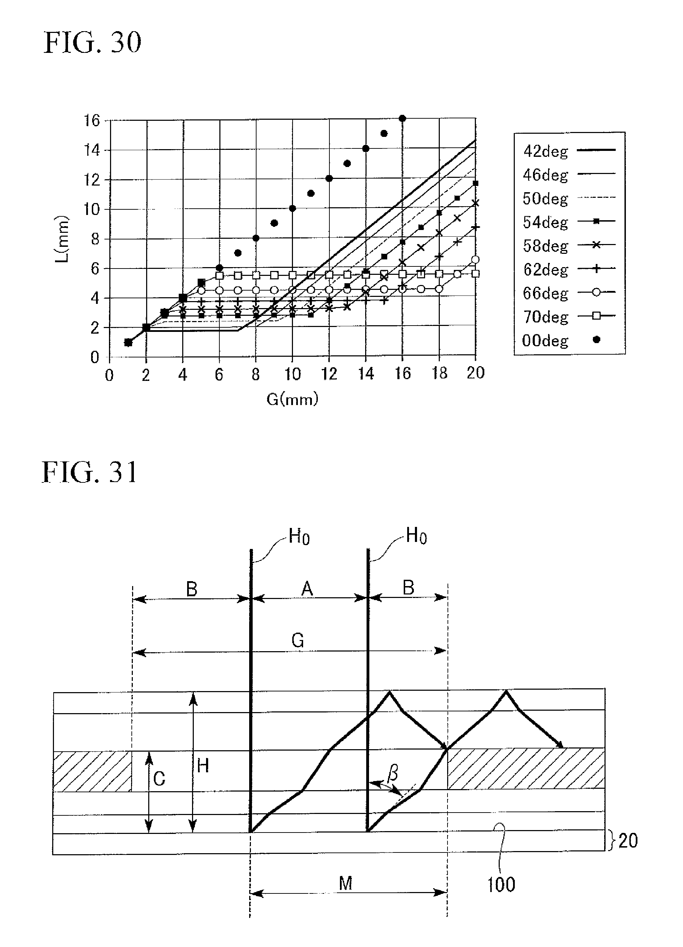

FIG. 30 shows an example of a relationship between the gaps G between the solar battery cells 30, and the length L of the loss areas B.

FIG. 30 shows a graph when the angle β formed between the incidence light H1 and the reflection light H2 was set to 0, 42, 46, 50, 54, 58, 62, 66, and 70 degrees, H was 5 mm, C was 2 mm, and W was 30 mm, and the gaps G between the solar battery cells 30 were between 1 mm and 20 mm.

The relationships between the length L of the loss areas B from among the gaps G between the solar battery cells 30 and the gaps G between the solar battery cells 30 were divided into three types.

In the first type, when there are small gaps G between the solar battery cells 30, the length L of the loss areas B from among the gaps G between the solar battery cells 30 is the same as the gaps G between the solar battery cells 30, and this is not preferable since the light H1 which is incident into the gaps G between the solar battery cells 30 is not used.

In the second type, when there are large gaps G between the solar battery cells 30, the length L of the loss areas B from among the gaps G between the solar battery cells 30 lengthens with increase in the gaps G between the solar battery cells 30, but this is preferable since the light H1 which is incident into the gaps G between the solar battery cells 30 is used.

In the third type, which is an intermediate type between the first type and the second type, even if the gaps G between the solar battery cells 30 become larger, the length L of the loss areas B from among the gaps G between the solar battery cells 30 does not change and there is no increase in loss so that this is the most preferable.

When the gaps G between the solar battery cells 30 are constant, the length L of the loss areas B from among the gaps G between the solar battery cells 30 changes depending on the angle β between the incidence light H1 and the reflection light H2.

For example, if the gaps G between the solar battery cells 30 are 4 mm, the angle β between the incidence light H1 and the reflection light H2 at which the length L of the loss areas B from among the gaps G between the solar battery cells 30 is the smallest is 42°.

As the angle β between the incidence light H 1 and the reflection light H2 becomes larger, the length L of the loss areas B from among the gaps G between the solar battery cells 30 also becomes longer.

At 58° or more, the length L of the loss area B is the same as the gaps G between the solar battery cells 30 so that the light H1 which is incident to the light reuse sheet 20 can no longer be used.

When the gaps G between the solar battery cells 30 are 10 mm, the angle β between the incidence light H1 and the reflection light H2 at which the length L of the loss area B is the shortest in this case is 54°.

At angles smaller (for example, 42°) than this angle and larger (for example, 70°) than this angle, the length L of the loss area B from among the gaps G between the solar battery cells 30 becomes longer.

Accordingly, when the gaps G between the solar battery cells 30 are 10 mm, 54° is the optimum angle for the angle β between the incidence light H1 and the reflection light H2.

Next, a case in which a plurality of layers are formed between the reflective surface 100 and the incident surface 110 will be described.

FIG. 31 is a conceptual view of a solar battery module 400 in which the space between the reflective surface 100 and the incident surface 110 is formed by a plurality of layers.

In cases such as this as well in which a plurality of layers are employed, because there is a small refractive index difference between the respective layers, even if a solar battery module is manufactured using the above-described conditions, it is possible to obtain a solar battery module 400 having a high power generation efficiency.

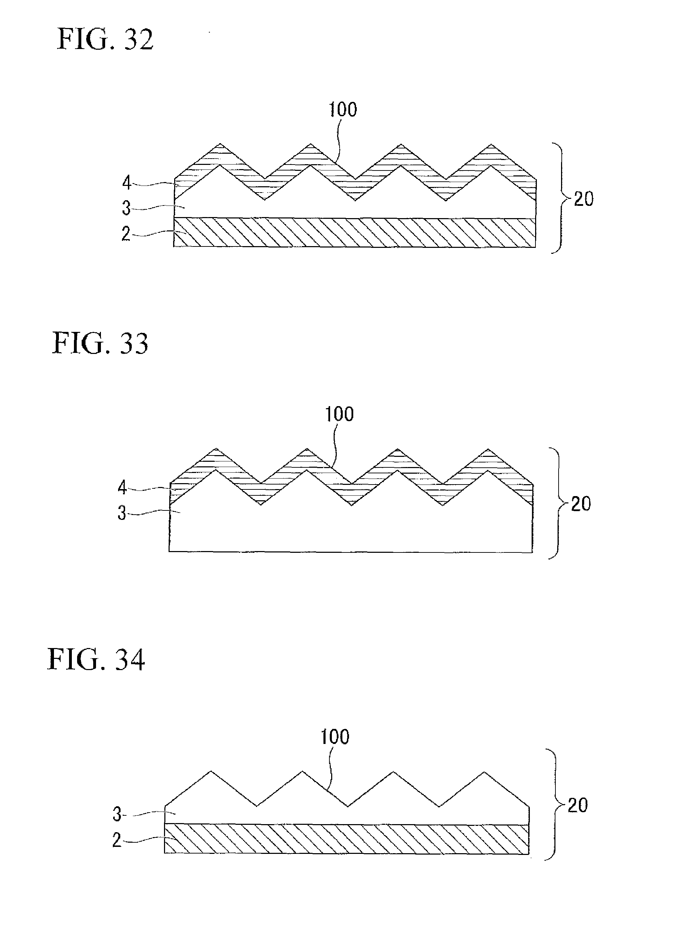

As shown in FIG. 32, the light reuse sheet 20 which is used in the above-described solar battery module 400 is formed by a structural layer 3, a reflective layer 4, and a base 2.

Examples of the method used to form an uneven configuration on the structural layer 3 include methods in which a thermosetting resin, an ultraviolet curable resin, an electron beam curable resin, or the like is either coated or injected into a mold on which the uneven configuration of a reflective surface 100 has been formed on a surface thereof. The base 2 is then placed on top of this, and curing processing is performed, after which the resin is released from the stamper mold.

Examples of the method used to manufacture a light reuse sheet 20 such as that shown in FIG. 33 which is formed solely from the structural layer 3 without using the base 2 include an integral molding method with the base 2 such as a press method using a mold, a casting method, an injection molding method, and the like.

According to the above-described method, it is possible to form the uneven configuration at the same time as the sheet is formed.

A mold manufactured by machine cutting can be employed for the mold used to form the reflective surface 100.

Moreover, it is possible to use molds manufactured by making duplicates of the above-described mold.

In this case, it is desirable for the shape of the distal ends of the uneven configuration to be a rounded shape in order to prevent any damage occurring to the distal ends of the uneven configuration.

It is also possible for the uneven configuration of the reflective surface 100 to have a periodic structure.

The uneven configuration of the above-described reflective surface 100 may also be a triangular, trapezoidal, or polygonal prism-shaped configuration, or various types of lens and prism configurations such as a cylindrical lens, or may be a semi-spherical configuration.

At this time, the pitch of the period of the structure of the uneven configuration of the reflective surface 100 is desirably less than or equal to 300 $\mu$m, and more desirably is less than or equal to 200 $\mu$m.

If the pitch of the period of the above-described structure is greater than 300 $\mu$m, there is a deterioration in moldability as it is difficult for resin to enter sufficiently into the mold in the distal end portions of the uneven configuration when the reflective surface 100 is being molded.

If the pitch of the period of the structure less than or equal to 200 $\mu$m, molding it is still possible even with a resin having a comparatively high viscosity.

Moreover, the smaller the pitch of the period of the above-described structure, the more difficult it is to manufacture the mold. Therefore, it is desirable for the pitch to be greater than or equal to 25 $\mu$m and more desirable for the pitch to be greater than or equal to 50 $\mu$m.

Namely, if the pitch of the period of the structure is less than 25 $\mu$m, the time needed to cut the mold increases so that there is a deterioration in the takt time and also in productivity.

If the pitch of the period of the above-described structure is less than 50 $\mu$m, then the resin does not properly fill the trenches of the uneven configuration when the reflective surface 100 is being molded, and it is not possible to make the shape of the distal end portions of the uneven configuration conform properly to the mold.

Furthermore, the thickness of the structural layer 3 is not particularly limited, however, it may be, for example, from 30 $\mu$m to 500 $\mu$m.

Additionally, the aforementioned manufacturing method may be appropriately selected based on its suitability for use with the following materials.

In the polymer composition used to form the structural layer 3, in addition to the polymer composition, where appropriate it is also possible to mix in, for example, a scattering reflector, a curing agent, a plasticizer, a dispersing agent, various types of leveling agent, ultraviolet ray absorption agents, antioxidants, viscosity modifiers, lubricants, and photostabilizers and the like.

Moreover, the above-described polymer composition is not particularly limited and examples thereof include poly (meth) acrylic resins, polyurethane resins, fluorine resins, silicone resins, polyimide resins, epoxy resins, polyethylene resins, polypropylene resins, methacrylic resins, polymethylpentene resins, cyclic polyolefin resins, polystyrene resins such as acrylonitrile (poly) styrene copolymers (AS resins) and acrylonitrile-butadiene-styrene copolymers (ABS resins), polyvinyl chloride resins, polycarbonate resins, polyester resins, polyamide resins, polyamide imide resins, polyarylphthalate resins, polysulfone resins, polyphenylene sulfide resins, polyether sulfone resins, polyethylene naphthalate resins, polyether imide resins, acetal resins, cellulose resins, and the like, and these polymers may be used either singly or in combinations of two or more.

Examples of the polyol which forms the raw material of the polyurethane resin include polyols obtained by polymerizing monomeric components that include hydroxyl-containing unsaturated monomers, or polyester polyols obtained in conditions of excessive hydroxyl, and these may be used either singly or in combinations of two or more.

Examples of the hydroxyl-containing unsaturated monomer include hydroxyl-containing unsaturated monomers obtained from a reaction between (a) hydroxyl-containing unsaturated monomers such as, for example, 2-hydroxyethyl acrylate, 2-hydroxypropyl acrylate, 2-hydroxyethyl methacrylate, 2-hydroxypropyl methacrylate, allyl alcohol, homoallylic alcohol, cinnamic alcohol, and crotonyl alcohol; and (b) dihydric alcohols or epoxy compounds such as, for example, ethylene glycol, ethylene oxide, propylene glycol, propylene oxide, butylene glycol, butylene oxide, 1,4-bis (hydroxymethyl) cyclohexane, phenyl glycidyl ether, glycidyl decanoate, and Placcel FM-1 (manufactured by Daicel Chemical Industries, Ltd.); and unsaturated carboxylic acids such as, for example, acrylic acid, methacrylic acid, maleic acid, fumaric

EP 2 355 166 A1

acid, crotonic acid, and itaconic acid.

It is possible to manufacture a polyol by polymerizing one or two or more of these hydroxyl-containing unsaturated monomers.

Moreover, the above-described polyol can be manufactured by polymerizing one or two or more ethylenic unsaturated monomers selected from: ethyl acrylate, n-propyl acrylate, isopropyl acrylate, n-butyl acrylate, tert-butyl acrylate, ethylhexyl acrylate, ethyl methacrylate, n-propyl methacrylate, isopropyl methacrylate, n-butyl methacrylate, tert-butyl methacrylate, ethylhexyl methacrylate, glycidyl methacrylate, cyclohexyl methacrylate, styrene, vinyl toluene, 1-methyl styrene, acrylic acid, methacrylic acid, acrylonitrile, vinyl acetate, vinyl propionate, vinyl stearate, allyl acetate, diallyl adipate, diallyl itaconate, diethyl maleate, vinyl chloride, vinylidene chloride, acrylamide, N-methylolacrylamide, N-(butoxymethyl) acrylamide, diacetone acrylamide, ethylene, propylene, and isoprene and the like; and a hydroxyl-containing unsaturated monomer selected from the above (a) and (b).

The number-average molecular weight of the polyol obtained by polymerizing a monomeric component containing a hydroxyl-containing unsaturated monomer is from 1000 to 500000, and preferably is from 5000 to 100000.

Moreover, the hydroxyl value thereof is from 5 to 300, and preferably from 10 to 200, and more preferably from 20 to than 150.

The polyester polyol obtained in conditions of excessive hydroxyl is manufactured by generating a reaction between: (c) polyhydric alcohols such as, for example, ethylene glycol, diethylene glycol, propylene glycol, dipropylene glycol, 1,3-butanediol, 1,4-butanediol, 1,5-butanediol, neopentyl glycol, hexamethylene glycol, decamethylene glycol, 2,2,4-trimethyl-1,3-pentanediol, trimethylolpropane, hexanetriol, glycerin, pentaerythritol, cyclohexanediol, hydrogenated bisphenol A, bis (hydroxymethyl) cyclohexane, hydroquinone bis (hydroxyethyl ether), tris (hydroxyethyl) isocyanurate, and xylylene glycol and; (d) polybasic acids such as, for example, maleic acid, fumaric acid, succinic acid, adipic acid, sebacic acid, azelaic acid, trimellitic acid, terephthalic acid, phthalic acid, and isophthalic acid and the like under the condition that the hydroxyl group number in the polyhydric alcohol such as propanediol, hexanediol, polyethylene glycol, and trimethylolpropane and the like is greater than the carboxyl group number of the polybasic acid.

The number-average molecular weight of the polyester polyol obtained under the above-described excessive hydroxyl conditions is from 500 to 300000, and preferably is from 2000 to 100000.

Moreover, the hydroxyl value thereof is from 5 to 300, and preferably from 10 to 200, and more preferably from 20 to 150.

The polyol that is used as the polymer material of the polymer composition is preferably the above-described polyester polyol, or an acrylic polyol which is obtained by polymerizing the above-described monomeric component containing a hydroxyl-containing unsaturated monomer, and which has a (meth) acrylic unit or the like.

If a polyester polyol or an acrylic polyol is used for the polyol material, then superior durability is obtained and any yellowing of the structural layer 3 is inhibited.

Additionally, either one of these polyester polyols and acrylic polyols may be used, or else both may be used.

Note also that the number of hydroxyl groups in the above-described polyester polyols and acrylic polyols is not particularly limited provided that there are two or more per molecule, however, if the hydroxyl value in the solid portion is 10 or less, there is a reduction in the number of cross-linking points and there is a tendency for the solvent resistance, water resistance, heat resistance, and coating properties such as surface hardness and the like to all deteriorate.

It is also possible to include a scattering reflector in the polymer composition which is used to form the structural layer 3 in order to improve the reflection properties, and the heat resistance thereof.

By including a scattering reflector in the polymer composition, the heat resistance of the structural layer 3 or the light reuse sheet 20 can be improved, and if a material having a refractive index which is considerably different from that of the polymer composition is used for the scattering reflector, then light can be reflected.

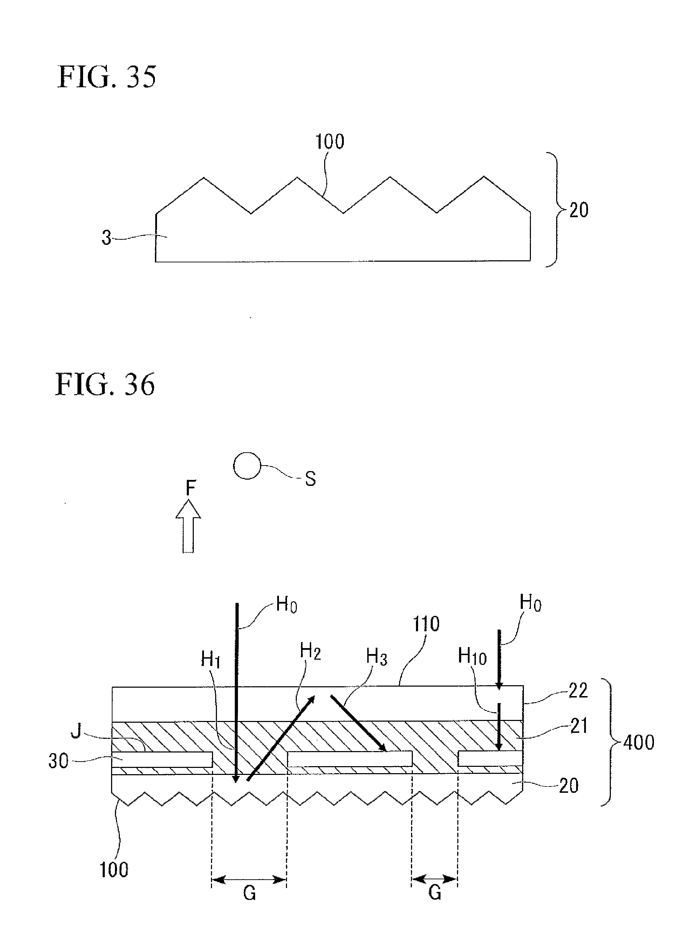

Additionally, if sufficient reflectance can be obtained in this manner, then, as shown in FIGS. 34 and 35, it is not necessary to provide the metal reflective layer 4.

The inorganic substance that makes up the scattering reflector is not particularly limited.

An inorganic oxide is preferably used as the inorganic substance.

Silica and the like can be used for this inorganic oxide, and metallic compounds such as ZnS and the like can also be used, however, metallic oxides such as $TiO_2$, ZrO, and $Al_2O_3$ and the like are particularly desirable.

Hollow grains of silica can also be used.

Of these, $TiO_2$ is preferable due to its high refractive index and its easily obtained dispersibility.

Furthermore, the shape of the scattering reflector is not particularly limited and the grains may be an optional shape such as a spherical shape, needle shape, plate shape, fish scale shape, or as fractured pieces.

The lower limit of the mean grain diameter of the scattering reflector is preferably 0.1 $\mu$m, and the upper limit thereof is preferably 30 $\mu$m.

If the mean grain diameter is less than 0.1 $\mu$m, light is not sufficiently reflected.

On the other hand, if the mean grain diameter is greater than 30 $\mu$m, then irregularities caused by the grains appear on the surface and it becomes difficult to form a desired uneven configuration.

The lower limit for the blending quantity of scattering reflector blended into 100 parts of the polymer composition is preferably 30 parts in terms of solid content.

In contrast, the upper limit for the blending quantity of scattering reflector is preferably 100 parts.

The reason for this is that, if the blending quantity of inorganic filling agent is less than 30 parts, the light H1 which is incident to the structural layer 3 from the packing layer 21 cannot be sufficiently reflected.

Conversely, if the blending quantity is greater than 100 parts, there is a deterioration in moldability.

A material having an organic polymer fixed to the surface thereof may be used as the above-described scattering reflector.

By using a scattering reflector to which an organic polymer has been fixed in this manner, improvements in the scattering performance in the polymer composition and in the affinity with the polymer composition are achieved.

The molecular weight, shape, composition, the presence or absence, or the like of a functional group and the like are not particularly restricted in this organic polymer, and a desired organic polymer can be used.

Moreover, a desired configuration such as a linear configuration, branched configuration, cross-linked structure, or the like can be used for the configuration of this organic polymer.

Specific examples of the resin making up the above-described organic polymer include polyolefins such as (meth) acrylic resin, polystyrene, polyvinyl acetate, and polyethylene, polyesters such as polyvinyl chloride, polyvinylidene chloride, and polyethylene terephthalate as well as copolymers of these, as well as resins partially denatured by a functional group such as an amino group, and epoxy group, a hydroxyl group, and a carboxyl group.

Among these, materials which have as their essential component an organic polymer containing a (meth) acrylic unit such as a (meth) acrylic resin, a (meth) acrylic-styrene resin, or a (meth) acrylic-polyester resin have a coating formation function and are, therefore, preferred.

Specific resins for forming the organic polymer are preferably resins that are compatible with the above-described polymer compositions and, accordingly, a material that has the same composition as the polymer composition is most preferable.

A polyol having a cycloalkyl group is preferable as the above-described polymer composition.

By introducing a cycloalkyl group into the polyol which is serving as the polymer composition, the hydrophobicity, for example, the water repellency and water resistance and the like of the polymer composition increases, and the flexural resistance and dimensional stability and the like of the structural layer 3 and the light reuse sheet 20 under high-temperature and high-humidity conditions are improved.

In addition, basic coating properties such as the weather resistance, hardness, and solvent resistance of the structural layer 3 are improved.

Furthermore, the affinity thereof with a scattering reflector having an organic polymer fixed to the surface thereof, as well as the dispersibility of the scattering reflector are improved.

It is also possible for an isocyanate to be included in the polymer composition as a curing agent.

By including an isocyanate curing agent in the polymer composition in this manner, a stronger cross-linked structure is obtained, and the coating properties of the structural layer 3 are further improved.

The same type of materials as the above-described polyfunctional isocyanate compounds are used as this isocyanate.

Among these, an aliphatic isocyanate which prevents yellowing of the coating is preferable.

Additionally, the scattering reflector may also include an internal organic polymer.

By employing this structure, a suitable consistency and toughness can be imparted to the inorganic substance foaming the core of the scattering reflector.

An alkoxy group is preferably included in the above-described organic polymer and, while the content thereof is not particularly restricted, it is preferably from 0.01 mmol to 50 mmol per gram of scattering reflector.

The affinity of the organic polymer with the polymer composition, as well as the dispersibility of the organic polymer in the polymer composition are improved by this alkoxy group.

The above-described alkoxy group shows an RO group which is coupled to a metallic element forming a fine grain lattice.

This R is a substitutable alkyl group, and the RO group in the fine particles may be the same or may be different.

Specific examples of the R include methyl, ethyl, n-propyl, isopropyl, and n-butyl and the like.

It is preferable to use the same metal alkoxy group as the metal used to make up the scattering reflector, while if the scattering reflector is colloidal silica, it is preferable to use an alkoxy group having silicon as its metal.

In the scattering reflector to which an organic polymer is fixed, the organic polymer content is not particularly restricted, however, using the scattering reflector as a reference, it is preferably from 0.5% by mass to 50% by mass.

When the light reuse sheet is 20 is constructed using the reflective layer 4, in order to improve the adhesiveness between them, surface processing may be performed on the surface onto which the reflective layer which is to be vapor-deposited (i.e., on the surface of the structural layer 3) (not shown).

Examples of this type of surface processing include: (a) corona discharge processing, ozone processing, low temperature plasma processing using oxygen gas or nitrogen gas, glow discharge processing, and oxidation processing using chemical agents and the like; (b) primer coating processing, undercoat processing, anchor coating processing, and vapor deposition anchor coating processing.

Among these surface processings, corona discharge processing and anchor coating processing are preferable as they provide improved adhesion strength with the reflective layer 4, and contribute to the formation of a precise and uniform reflective layer 4.

Examples of the anchor coating agent used in the aforementioned anchor coating processing include polyester-based anchor coating agents, polyamide-based anchor coating agents, polyurethane-based anchor coating agents, epoxy-based anchor coating agents, phenol-based anchor coating agents, (meth) acrylic-based anchor coating agents, polyvinyl acetate-based anchor coating agents, polyolefin-based anchor coating agents such as polyethylene and polypropylene, and cellulose-based anchor coating agents.

Among these anchor coating agents, polyester-based anchor coating agents are particularly preferable as they make it possible to further improve the adhesion strength of the reflective layer 4.

The coating quantity (in terms of solid content) of the aforementioned anchor coating agents is preferably from 1 g/m$^2$ to 3 g/m$^2$.

If the coating quantity of the anchor coating agent is less than 1 g/m$^2$, the effectiveness of the improvement in the adhesion of the reflective layer 4 is diminished.

If, however, the coating quantity of the anchor coating agent is greater than 3 g/m$^2$, there is a possibility that the strength and durability and the like of the light reuse sheet 20 will deteriorate.

Additionally, in the above-described anchor coating agent it is also possible to suitably blend various additives such as a silane coupling agent which is used to improve the tightness of the adhesive bond, a blocking inhibitor which is used to prevent blocking, and an ultraviolet ray absorption agent which is used to improve the weatherproofness and the like thereof.

The blending quantity of these additives is preferably from 0.1% by weight to 10% by weight in order to maintain a balance between manifesting the effect of the additives and functional inhibition of the anchor coating agent.

If the blending quantity of the above-described additives is less than 0.1 % by weight, then it is not possible to satisfactorily prevent blocking and sufficient weatherproofness cannot be obtained. On the other hand, if the blending quantity is greater than 10% by weight, the functions of the top coating agent are inhibited.

The reflective layer 4 is a layer that reflects light which is incident to the light reuse sheet 20.

The reflective layer 4 is formed by vapor-depositing a metal over the surface of the structural layer 3 on which the uneven configuration is formed.

The vapor deposition apparatus which is used to form the reflective layer 4 is not particularly restricted provided that it is able to deposit a metal without this leading to any deterioration such as contraction or yellowing of the structural layer 3.

(a) Physical vapor deposition (PVD) methods such as a vacuum deposition method, a sputtering method, an ion plating method, and an ion cluster beam method and the like, and (b) Chemical vapor deposition (CVD) methods such as a plasma chemical vapor deposition method, a thermal chemical vapor deposition method, and a photochemical vapor deposition method and the like are employed.

Among these deposition methods, a vacuum deposition method or an ion plating method are preferable as they have high productivity and make it possible to form a superior reflective layer 4.

Moreover, the metal which is used for the reflective layer 4 is not particularly restricted provided that it has metallic luster and can be vapor-deposited.

Examples of the metal used for the reflective layer 4 include aluminum, silver, gold, nickel, tin, zirconium and the like.

Among these, aluminum is preferable as it is highly reflective and allows a precise reflective layer 4 to be formed comparatively easily.

Additionally, the reflective layer 4 may be a single layer structure or may be a multilayer structure made up of two or more layers.

By forming the reflective layer 4 as a multilayer structure in this manner, there is less deterioration of the structural layer 3 due to the lessening of the thermal load generated during the vapor deposition, and the adhesiveness between the structural layer 3 and the reflective layer 4 can be further improved.

At this time, it is also possible to provide a metal oxide layer on top of the metal film.

Furthermore, the vapor deposition conditions in the above-described physical vapor deposition method and chemical vapor deposition method are suitably designed in accordance with the types of resin used for the structural layer 3 and the base 2, and the thickness of the reflective layer 4 and the like.

The lower limit for the thickness of the reflective layer 4 is preferably 10 nm, and 20 nm is particularly preferable.

The upper limit for the thickness of the reflective layer 4 is preferably 200 nm, and 100 nm is particularly preferable.

If the thickness of the reflective layer 4 is less than the lower limit of 10 nm, then it is no longer possible to satisfactorily reflect light which is incident to the reflective layer 4 from the packing layer 21.

Moreover, even if the thickness is greater than 20 nm, there is no further increase in the amount of light reflected by the reflective layer 4 so that a thickness of 20 nm can be said to be sufficient.

On the other hand, if the thickness of the reflective layer 4 is greater than the upper limit of 200 nm, cracks that are visually confirmed occur in the reflective layer 4.

Moreover, it is beneficial for top coat processing to be performed on the outer surface of the reflective layer 4 (not shown).

By performing top coat processing on the outer surface of the reflective layer 4 in this manner, the reflective layer 4 is sealed and protected, so that, as a result, the ease of handling the light reuse sheet 20 is improved.

Moreover, deterioration over time of the reflective layer 4 is suppressed.

Examples of the top coating agent used in the above-described top coat processing include polyester-based top coating agents, polyamide-based top coating agents, polyurethane-based top coating agents, epoxy-based top coating agents, phenol-based top coating agents, (meth) acrylic-based top coating agents, polyvinyl acetate-based top coating agents, polyolefin-based top coating agents such as polyethylene and polypropylene, and cellulose-based top coating agents.

Among these top coating agents, polyester-based top coating agents are particularly preferable as they have a high adhesion strength with the reflective layer 4, and they contribute to protecting the surface of the reflective layer 4 and also to sealing any defects and the like.

The coating quantity (in terms of solid content) of the aforementioned top coating agents is preferably from 3 g/m$^2$ to 7 g/m$^2$.

If the coating quantity of the anchor coating agent is less than 3 g/m$^2$, the effectiveness of the sealing and protection of the reflective layer 4 is diminished.

However, even if the coating quantity of the anchor coating agent is greater than 7 g/m$^2$, there is essentially no further increase in the sealing and protection effect of the reflective layer 4, while there is an increase in the thickness of the light reuse sheet 20.

Additionally, in the above-described top coating agent it is also possible to suitably blend various additives such as a silane coupling agent which is used to improve the tightness of the adhesive bond, an ultraviolet ray absorption agent which is used to improve weatherproofness and the like, and an inorganic filler or the like which is used to improve heat resistance and the like.

The blending quantity of these additives is preferably from 0.1 % by weight to 10% by weight in order to maintain a balance between manifesting the effect of the additives and functional inhibition of the top coating agent.

If the blending quantity of the above-described additives is less than 0.1% by weight, then it is not possible to obtain satisfactory adhesiveness, weatherproofness, and heat resistance. On the other hand, if the blending quantity is greater than 10% by weight, the functions of the top coating agent are inhibited.

The base 2 which forms part of the light reuse sheet 20 is formed by sheet molding using synthetic resin as the material.

In view of the fact that it will be located outdoors, the synthetic resin used for the base 2 is desirably a material having weatherproof properties such as water resistance and durability against ultraviolet rays.

Examples thereof include polyethylene resins such as polyethylene terephthalate resin (PET resin), polypropylene resins, (meth) acrylic resins, polymethylpentene resins, cyclic polyolefin resins, polystyrene resins, acrylonitrile (poly) styrene copolymers (AS resins), acrylonitrile-butadiene-styrene copolymers (ABS resins), polyvinyl chloride resins, fluorine resins, poly (meth) acrylic resins, polycarbonate resins, polyester resins, polyamide resins, polyimide resins, polyamide imide resins, polyarylphthalate resins, silicone resins, polysulfone resins, polyphenylene sulfide resins, polyether sulfone resins, polyethylene naphthalate resins, polyether imide resins, epoxene resins, polyurethane resins, acetal resins, and cellulose resins and the like.

Among the above resins, polyimide reins, polycarbonate resins, polyester resins, fluorine resins, and polylactic acid resins are preferable as resins that have high heat resistance, strength, weatherproofness, durability, and gas barrier properties against water vapor and the like.

Examples of the aforementioned polyester resins include polyethylene terephthalate and polyethylene naphthalate and the like.

Among these polyester resins, polyethylene terephthalate is particularly preferable due to its excellent balance between its various functionalities such as heat resistance and weatherproofness and its low cost.

Examples of the aforementioned fluorine resins include polytetrafluoroethylene (PTFE), perfluoroalkoxy resin (PFA) formed by a copolymer of tetrafluoroethylene and perfluoroalkyl vinyl ether, a copolymer of tetrafluoroethylene and hexafluoropropylene (FEP), a copolymer of tetrafluoroethylene, perfluoroalkyl vinyl ether, and hexafluoropropylene (EPE), a copolymer of tetrafluoroethylene and ethylene or propylene (ETFE), polychlorotrifluoroethylene resin (PCTFE), a copolymer of ethylene and chlorotrifluoroethylene (ECTFE), polyvinylidene fluoride resin (PVDF), and polyvinyl fluoride resin (PVF).

Among these fluorine resins, polyvinyl fluoride resin (PVF) and a copolymer of tetrafluoroethylene and ethylene or propylene (ETFE) are particularly preferable due to their superior strength, heat resistance, and weatherproofness.

Examples of the aforementioned cyclic polyolefin resins include: (a) polymers obtained by polymerizing cyclic dienes such as cyclopentadiene (and derivatives thereof), dicyclopentadiene (and derivatives thereof), cyclohexadiene (and derivatives thereof), and norbomadiene (and derivatives thereof); and (b) copolymers obtained by polymerizing a cyclic diene with one or two or more olefin-based monomers such as ethylene, propylene, 4-methyl-1-pentene, styrene, butadiene, and isoprene.

Among these cyclic olefin resins, polymers of cyclic dienes such as cyclopentadiene (and derivatives thereof), dicyclopentadiene (and derivatives thereof), and norbomadiene (and derivatives thereof) are particularly preferable due to their superior strength, heat resistance, and weatherproofness.

Additionally, either one of the above-described synthetic resins, or two or more mixed together can be used as the material forming the base 2.

In addition, in the material used to form the base 2 it is also possible to blend various additives in order to improve and refine the workability, heat resistance, weatherproofness, mechanical properties, and dimensional stability and the like thereof.

Examples of such additives include lubricants, cross-linking agents, anti-oxidants, ultraviolet ray absorption agents, photostabilizers, filling materials, reinforcing fibers, reinforcing agents, antistatic agents, flame retardants, fire retardants, foaming agents, fungicides, pigments and the like.

The method used to form the base 2 is not particularly restricted and a known method may be used such as, for example, an extrusion method, a cast molding method, a T-die casting method, a cutting method, and an inflation method.

If the base 2 is used, then the thickness thereof is preferably from 25 $\mu$m to 500 $\mu$m, and, more preferably, 250 $\mu$m.

If the thickness of the base 2 is thinner than 25 $\mu$m, curling is generated during the coating processing of the structural layer 3 from the effects of curing contraction of the ultraviolet curable resin and the like, and defects occur when the solar battery cells are assembled into the solar battery module 400.

Conversely, if the thickness of the base 2 is greater than 500 $\mu$m, the weight of the film increases, so that the weight of the solar battery module 400 also increases.

If the thickness is less than or equal to 250 $\mu$m, then a more lightweight solar battery module 400 can be achieved.

It is also possible to include an ultraviolet stabilizer or a polymer having an ultraviolet stabilizer group coupled to the molecular chain thereof in the base 2 or the structural layer 3.

Radicals and active oxygen and the like are generated by ultraviolet rays are deactivated by the ultraviolet stabilizer or the ultraviolet stabilizer group, and it is thereby possible to improve the ultraviolet stability and the weatherproofness and the like of the light reuse sheet 20.

Hindered amine-based ultraviolet stabilizers or hindered amine-based ultraviolet stabilizer groups which have excellent stability against ultraviolet rays are preferably used as the ultraviolet stabilizer or ultraviolet stabilizer group.

According to a solar battery module 400 which uses the light reuse sheet 20 having the above-described structure, light incident to the areas R1 between mutually adjacent solar battery cells 30 is reflected by the reflective surface 100 of the light reuse sheet 20 and can be incident to the solar battery cells 30.

As a result of this, it is possible to use this light that is incident to the areas R1 between mutually adjacent solar battery cells 30, and the power generation efficiency of the solar battery module 400 can be improved.

As shown in FIG. 36, it is also possible to arrange the light reuse sheet 20 such that the rear surface of the reflective surface 100 of the light reuse sheet 20 is facing toward the packing layer 21 side.

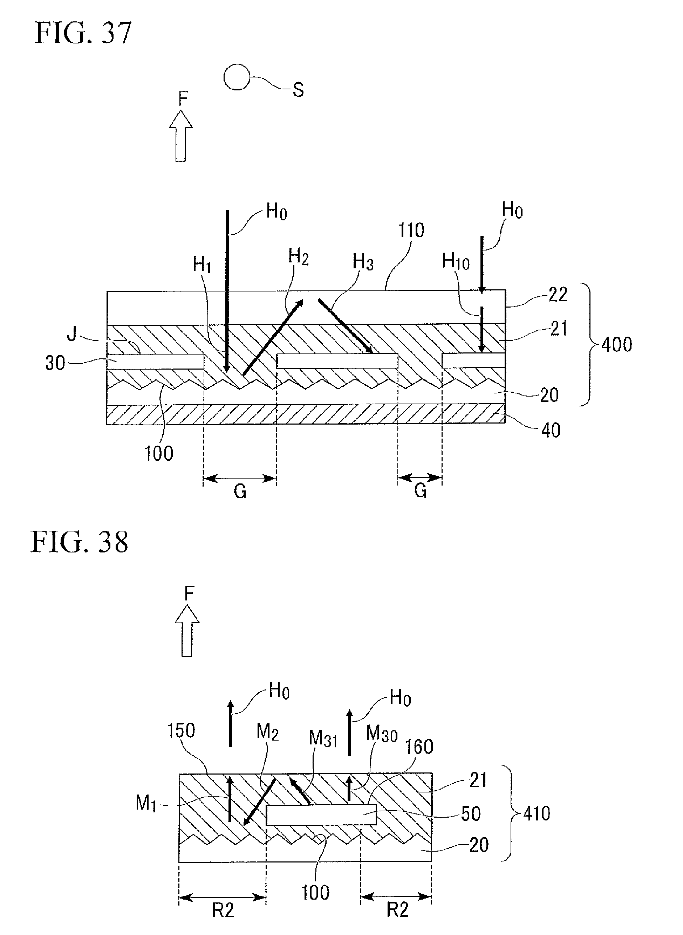

As shown in FIG. 37, it is also possible to use a structure in which this light reuse sheet 20 includes a barrier layer made of either an aluminum layer having a thickness of 10 $\mu$m to 30 $\mu$m, or a silica layer having a thickness of 10 nm through 100 nm.

Furthermore, in order to increase durability, it is also possible to protect the solar battery module by coating PVF (polyvinyl fluoride resin) thereon, or by adhering thereon a film having polyvinyl fluoride resin.

By employing this type of structure, the solar battery module 400 can also be used as a backing sheet.

As shown in FIG. 38, the light reuse sheet 20 can also be used for reusing light from a solid light emitting element 50 such as an LED or EL or the like.

FIG. 38 is a cross-sectional view showing an embodiment of a light source module 410 according to the present invention.

This light source module 410 has a packing layer 21, a light emitting element 50, and a light reuse sheet 20.

The light emitting element 50 has a function of converting electricity into light by electroluminescence, and emits this light from a light receiving and emitting surface 160.

A solid light emitting diode such as an LED, organic EL, inorganic EL, or the like is preferably used for the light emitting element 50.

The packing layer 21 is a layer which seals the light emitting element 50. Light which is emitted from the light emitting element 50 passes through the packing layer 21 and a portion thereof becomes light M30 which is emitted from an emission surface 150, while the remainder becomes light M31 which is reflected by the emission surface 150.

A material having a high light transmittance in order to transmit the light incident to the packing layer 21 is used for the packing layer 21, and an acrylic resin or the like having a high transmittance is preferably used.

The portion M31 of the light emitted from the light emitting element 50 which is to be reflected by the emission surface 150 is reflected by the emission surface 150 and is incident to the reflective surface 100 of the light reuse sheet 20.

Light M2 which is incident to the reflective surface is reflected by the reflective surface 100, and is incident to the emission surface 150.

Reflection light M1 which is reflected by the reflective surface 100 and is incident to the emission surface 150 is emitted to the outside via the emission surface 150.

As a result, compared with a structure in which there is no light reuse sheet 20, the effect is obtained that the light utilization efficiency can be improved.

The above-described effect is only obtained from the light reuse sheet 20 when the relationship between the lengths and placement of the light emitting element 50 and light reuse sheet 20 and the angle β between the reflected light M1 and the light M2 which is incident to the reflective surface is within a suitable range.

This relationship preferably satisfies Formula 2, and more preferably also satisfies Formulas 3 and 4, and still more preferably also satisfies Formula 5, and even more preferably also satisfies Formula 6.

(Example 5)

In Example 5, a PET film having a thickness of 250 μm was used for the base 2.

For the structural layer 3, a layer in which a triangular prism-shaped uneven configuration having a pitch of 150 μm and an apex angle of the reflective surface 100 of 135° was formed from an ultraviolet curable acrylic resin was stacked on a PET film, and for the metallic reflective layer 4, an aluminum layer having a thickness of 100 nm was formed by vapor-deposition so as to form a light reuse sheet 20.

A solar battery module 400 was then manufactured using a light reuse sheet 20 which was manufactured in this manner.

A glass plate having a thickness of approximately 3 mm was used for the front-surface plate 22, and a packing layer 21 having a thickness of approximately 0.5 mm was formed thereon by filling EVA so that the solar battery cells 30 were positioned 0.5 mm from the front-surface plate 22.

Polycrystalline silicon solar cells formed in a square shape having a length of 150 mm and a thickness of 0.2 mm were used for the solar battery cells 30, and the above-described light reuse sheet 20 having a width of approximately 25 mm was placed around the periphery of the solar battery cells 30 at a position of 0.5 mm from the light receiving surface J of the solar battery cells 30, and the power generation efficiency thereof was then measured

The results for this power generation efficiency are shown in Table 2.

(Example 6)

In Example 6, a PET film having a thickness of 250 μm was used for the base 2.

For the structural layer 3, a layer in which a triangular prism-shaped uneven configuration having a pitch of 200 μm and an apex angle of the reflective surface 100 of 120° was formed from an ultraviolet curable acrylic resin was stacked on a PET film, and for the metallic reflective layer 4, an aluminum layer having a thickness of 100 nm was formed by vapor-deposition so as to form a light reuse sheet 20.

A solar battery module 400 was then manufactured using a light reuse sheet 20 which was manufactured in this manner.

A glass plate having a thickness of approximately 3 mm was used for the front-surface plate 22, and a packing layer 21 having a thickness of approximately 0.5 mm was formed thereon by filling EVA so that the solar battery cells 30 were positioned 0.5 mm from the front-surface plate 22.

Polycrystalline silicon solar cells formed in a square shape having a length of 150 mm and a thickness of 0.2 mm were used for the solar battery cells 30, and the above-described light reuse sheet 20 having a width of approximately 25 mm was placed around the periphery of the solar battery cells 30 at a position of 0.5 mm from the light receiving surface J of the solar battery cells 30, and the power generation efficiency thereof was then measured

The results for this power generation efficiency are shown in Table 2.

(Example 7)

In Example 7, a PET film having a thickness of 250 μm was used for the base 2.

For the structural layer 3, a layer in which a triangular prism-shaped uneven configuration having a pitch of 200 μm and an apex angle of the reflective surface 100 of 115° was formed from an ultraviolet curable acrylic resin was stacked on a PET film, and for the metallic reflective layer 4, an aluminum layer having a thickness of 100 nm was formed by vapor-deposition so as to form a light reuse sheet 20.

A solar battery module 400 was then manufactured using a light reuse sheet 20 which was manufactured in this manner.

A glass plate having a thickness of approximately 3 mm was used for the front-surface plate 22, and a packing layer 21 having a thickness of approximately 0.5 mm was formed thereon by filling EVA so that the solar battery cells 30 were positioned 0.5 mm from the front-surface plate 22.

Polycrystalline silicon solar cells formed in a square shape having a length of 150 mm and a thickness of 0.2 mm were used for the solar battery cells 30, and the above-described light reuse sheet 20 having a width of approximately 25 mm was placed around the periphery of the solar battery cells 30 at a position of 0.5 mm from the light receiving surface J of the solar battery cells 30, and the power generation efficiency thereof was then measured

The results for this power generation efficiency are shown in Table 2.

(Example 8)

In Example 8, a PET film having a thickness of 250 μm was used for the base 2.

For the structural layer 3, a layer in which a prism-shaped uneven configuration having a pitch of 15 μm and an apex angle of the reflective surface 100 of 135° was formed from an ultraviolet curable acrylic resin was stacked on a PET film, and for the metallic reflective layer 4, an aluminum layer having a thickness of 100 nm was formed by vapor-deposition so as to form a light reuse sheet 20.

A solar battery module 400 was then manufactured using this.

A glass plate having a thickness of approximately 3 mm was used for the front-surface plate 22, and a packing layer 21 having a thickness of approximately 0.5 mm was formed thereon by filling EVA so that the solar battery cells 30 were positioned 0.5 mm from the front-surface plate 22.

Polycrystalline silicon solar cells formed in a square shape having a length of 150 mm and a thickness of 0.2 mm were used for the solar battery cells 30, and the above-described light reuse sheet 20 having a width of approximately 25 mm was placed around the periphery of the solar battery cells 30 at a position of 1.0 mm from the light receiving surface J of the solar battery cells 30, and the power generation efficiency thereof was then measured

The results for this power generation efficiency are shown in Table 2.

(Example 9)

In Example 9, a PET film having a thickness of 250 μm was used for the base 2.

For the structural layer 3, a layer in which a prism-shaped uneven configuration having a pitch of 15 μm and an apex angle of the reflective surface 100 of 120° was formed from an ultraviolet curable acrylic resin was stacked on a PET film, and for the metallic reflective layer 4, an aluminum layer having a thickness of 100 nm was formed by vapor-deposition so as to form a light reuse sheet 20.

A solar battery module 400 was then manufactured using a light reuse sheet 20 which was manufactured in this manner.

A glass plate having a thickness of approximately 3 mm was used for the front-surface plate 22, and a packing layer 21 having a thickness of approximately 0.5 mm was formed thereon by filling EVA so that the solar battery cells 30 were positioned 0.5 mm from the front-surface plate 22.

Polycrystalline silicon solar cells formed in a square shape having a length of 150 mm and a thickness of 0.2 mm were used for the solar battery cells 30, and the above-described light reuse sheet 20 having a width of approximately 25 mm was placed around the periphery of the solar battery cells 30 at a position of 1.0 mm from the light receiving surface J of the solar battery cells 30, and the power generation efficiency thereof was then measured

The results for this power generation efficiency are shown in Table 2.

(Comparative example 2)

In Comparative example 2, a PET film having a thickness of 250 μm was used for the base 2.

Without forming the structural layer 3, an aluminum layer having a thickness of 100 nm was formed by vapor-deposition as the metallic reflective layer 4 so as to obtain a light reuse sheet 20.

A solar battery module 400 was then manufactured using a light reuse sheet 20 which was manufactured in this manner.

A glass plate having a thickness of approximately 3 mm was used for the front-surface plate 22, and a packing layer 21 having a thickness of approximately 0.5 mm was formed thereon by filling EVA so that the solar battery cells 30 were positioned 0.5 mm from the front-surface plate 22.

Polycrystalline silicon solar cells formed in a square shape having a length of 150 mm and a thickness of 0.2 mm were used for the solar battery cells 30, and the above-described light reuse sheet 20 having a width of approximately 25 mm was placed around the periphery of the solar battery cells 30 at a position of 0.5 mm from the light receiving surface J of the solar battery cells 30, and the power generation efficiency thereof was then measured.

The results for this power generation efficiency are shown in Table 2.

(Table 2)

|  | RELATIVE POWER GENERATION EFFICIENCY |
|---|---|
| EXAMPLE 5 | 110. 9% |
| EXAMPLE 6 | 112. 7% |
| EXAMPLE 7 | 115. 8% |
| EXAMPLE 8 | 110. 1% |
| EXAMPLE 9 | 111. 0% |
| COMPARATIVE EXAMPLE 2 | 100. 0% |

Industrial applicability

As described in detail above, the present invention is useful in a light reuse sheet that has an uneven structure on at least one surface thereof, and that deflects light in a specific direction using the diffraction, scattering, refraction or reflection action of light by using this uneven structure so that light that would have been conventionally lost can be reused, and to a solar battery module and light source module in which this light reuse sheet is used.

**Claims**

1. A light reuse sheet comprising a reflective surface having an uneven configuration, the reflective surface being formed so as to satisfy the following formula in order to reflect light in a specific direction so as to cause light to be incident to a solar battery cell, the light being incident to a solar battery module, or in order to exit light in a specific direction by reflecting the light, the light being emitted from a light emitting element of a light source module.

(Formula 1)

$$\frac{df}{d\phi} = 0 = Ly \cdot \cos\phi - Lx \cdot \sin\phi - A(\cos^2\phi - \sin^2\phi)$$

Lx: a length in a horizontal direction of a solar battery cell or a light emitting element
Ly: a length in a vertical direction of a solar battery cell or a light emitting element
φ: an angle formed between a direction of an uneven configuration of the reflective surface and an edge in a horizontal direction of the solar battery cell or the light emitting element
A: maximum width of light which passes between adjacent solar battery cells and which is reflected by a light reuse sheet and is incident to a light receiving face of a solar battery cell, or maximum width of light which is not emitted from a light emitting element in a specific direction and which exits in a specific direction by reflecting the light at a light reuse sheet

2. The light reuse sheet according to claim 1, wherein
in a case where the length in the horizontal direction Lx of the solar battery cell or the light emitting element is equivalent to the length Ly in the vertical direction thereof, or in a case where a long side thereof is less than or equal to twice the short side thereof,
the reflective surface is formed so as to satisfy φ = 45°±20°.

3.  The light reuse sheet according to claim 1, wherein
    in a case where the length in the horizontal direction Lx of the solar battery cell or the light emitting element is different from the length Ly in the vertical direction and a long side thereof is greater than or equal to twice the short side thereof,
    the reflective surface is formed so as to satisfy φ = 60°±20° (Lx < Ly) or φ = 30°±20° (Ly < Lx).

4.  The light reuse sheet according to claim 1, wherein
    a width in a horizontal direction or a vertical direction of the solar electron cell or the light emitting element is equivalent to the maximum width A of the light; and
    the reflective surface is formed so as to satisfy φ = 0° when the width in the horizontal direction is equivalent to the maximum width A of the light, or the reflective surface is formed so as to satisfy φ = 90° when the width in the vertical direction is equivalent to the maximum width A of the light.

5.  A solar battery module comprising:

    a front-surface plate to which light is incident;
    a packing layer, through which the light passing through the front-surface plate passes;
    a solar battery cell which has a light receiving surface and a rear face opposite to the light receiving surface, which is fixed by the packing layer, and which converts the light passing through the packing layer into electricity by receiving the light at the light receiving surface; and
    a light reuse sheet which is disposed so as to face the rear face of the solar battery cell, and which reflects the light passing between the solar battery cell adjacent to each other and has a reflective surface having an uneven configuration that causes the solar battery cell to receive the light, wherein
    the light reuse sheet is the light reuse sheet according to any one of claims 1 to 4.

6.  A light source module comprising:

    a packing layer through which light passes, and which has an emission surface;
    a light emitting element fixed by the packing layer, having a light emitting surface and a rear face opposite to the light emitting surface, converting electricity into light, emitting the light from the light emitting surface, and causing the light to be reflected by the emission surface of the packing layer; and
    a light reuse sheet which is disposed so as to face the rear face of the light emitting element and which has a reflective surface having an uneven configuration, the uneven configuration causing the light reflected by the emission surface of the packing layer to be re-reflected toward the emission surface, wherein
    the light reuse sheet is the light reuse sheet according to any one of claims 1 to 4.

7.  A solar battery module comprising:

    a front-surface plate to which light is incident;
    a packing layer, through which the light passing through the front-surface plate passes;
    a solar battery cell which has a light receiving surface and a rear face opposite to the light receiving surface, which is fixed by the packing layer, and which converts the light passing through the packing layer into electricity by receiving the light at the light receiving surface; and
    a light reuse sheet which is disposed so as to face the rear face of the solar battery cell, and which has a reflective surface having an uneven configuration reflecting the light that is not received by the light receiving surface of the solar battery cell, wherein
    the reflective surface satisfies the following formula where a distance between the reflective surface of the light reuse sheet and the light receiving surface of the solar battery cell is represented by C, an angle formed between the light incident to the light reuse sheet and the light reflected by the light reuse sheet is represented by β, and an interval of a gap between solar battery cells is represented by G.

(Formula 2)

$$C \cdot \tan \beta < G$$

8.  The solar battery module according to claim 7, wherein
    the reflective surface of the light reuse sheet satisfies the following formulas where a distance between the incident face of the solar battery module and the reflective surface of the light reuse sheet is represented by H and a width of the solar battery cell is represented by W.

(Formula 3)

$$(2H - C)\cdot\tan\beta - W \leq G \leq (2H - C)\cdot\tan\beta$$

or

(Formula 4)

$$(2H - C)\cdot\tan\beta \leq G$$

9. The solar battery module according to claims 7 or 8, wherein
the reflective surface of the light reuse sheet satisfies the following formula.

(Formula 5)

$$G = (2H - C)\cdot\tan\beta$$

10. A solar battery module comprising:

a front-surface plate to which light is incident;
a packing layer, through which the light passing through the front-surface plate passes;
a solar battery cell which has a light receiving surface and a rear face opposite to the light receiving surface, which is fixed by the packing layer, and which converts the light passing through the packing layer into electricity by receiving the light at the light receiving surface; and
a light reuse sheet which is disposed so as to face the rear face of the solar battery cell, and which has a reflective surface having an uneven configuration reflecting the light that is not received by the light receiving surface of the solar battery cell, wherein
the solar battery module has the reflective surface satisfying the following formula where a distance between the reflective surface of the light reuse sheet and the light receiving surface of the solar battery cell is represented by C.

(Formula 6)

$$C = 0$$

# FIG. 1

# FIG. 2

FIG. 3

FIG. 4

FIG. 5

## FIG. 6

## FIG. 7

## FIG. 8A

## FIG. 8B

## FIG. 9A

## FIG. 9B

FIG. 10

# FIG. 11

## FIG. 12

## FIG. 13

## FIG. 14

## FIG. 15

# FIG. 16

# FIG. 17

FIG. 18

FIG. 19

## FIG. 20

## FIG. 21

## FIG. 22

## FIG. 23

## FIG. 24

## FIG. 25

FIG. 26

FIG. 27

FIG. 28

FIG. 29

# FIG. 30

# FIG. 31

FIG. 32

FIG. 33

FIG. 34

FIG. 35

FIG. 36

## FIG. 37

## FIG. 38

FIG. 39

| INTERNATIONAL SEARCH REPORT | International application No. |
|---|---|
| | PCT/JP2009/006237 |

A. CLASSIFICATION OF SUBJECT MATTER
*H01L31/042*(2006.01)i, *H01L33/00*(2010.01)i

According to International Patent Classification (IPC) or to both national classification and IPC

B. FIELDS SEARCHED

Minimum documentation searched (classification system followed by classification symbols)
H01L31/042, H01L33/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2000-101124 A (Hitachi, Ltd.),<br>07 April 2000 (07.04.2000),<br>paragraphs [0021] to [0025], [0083]; fig. 2, 29<br>& US 6323415 B1 | 1-5<br>6 |
| Y | JP 2005-244095 A (Matsushita Electric Industrial Co., Ltd.),<br>08 September 2005 (08.09.2005),<br>fig. 9<br>(Family: none) | 6 |
| A | JP 11-243225 A (Hitachi, Ltd.),<br>07 September 1999 (07.09.1999),<br>paragraphs [0004], [0010]; fig. 4<br>& US 2001/0008144 A1 & DE 19907506 A | 1-6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 12 February, 2010 (12.02.10) | 23 February, 2010 (23.02.10) |

| Name and mailing address of the ISA/<br>Japanese Patent Office | Authorized officer |
|---|---|
| | |
| Facsimile No. | Telephone No. |

Form PCT/ISA/210 (second sheet) (April 2007)

**INTERNATIONAL SEARCH REPORT**

| International application No. |
|---|
| PCT/JP2009/006237 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2001-516149 A  (Daystar Technologies, Inc.), 25 September 2001 (25.09.2001), entire text; all drawings & US 6008449 A          & WO 1999/009601 A1 | 1-6 |
| A | JP 2002-43600 A  (President of Tokyo University of Agriculture and Technology), 08 February 2002 (08.02.2002), entire text; all drawings (Family: none) | 1-6 |
| A | JP 2006-147984 A  (Sanyo Electric Co., Ltd.), 08 June 2006 (08.06.2006), entire text; all drawings & US 2006/0107991 A1     & EP 1662582 A2 | 1-6 |
| A | JP 2006-344964 A  (General Electric Co.), 21 December 2006 (21.12.2006), entire text; all drawings & US 2006/0272698 A1     & EP 1732141 A1 | 1-6 |
| A | JP 2005-159149 A  (Aoki Denki Kogyo Kabushiki Kaisha), 16 June 2005 (16.06.2005), entire text; all drawings (Family: none) | 1-6 |
| A | JP 11-307791 A  (Sanyo Electric Co., Ltd.), 05 November 1999 (05.11.1999), entire text; all drawings (Family: none) | 1-6 |

Form PCT/ISA/210 (continuation of second sheet) (April 2007)

**INTERNATIONAL SEARCH REPORT**

| International application No. |
| --- |
| PCT/JP2009/006237 |

| Box No. II | Observations where certain claims were found unsearchable (Continuation of item 2 of first sheet) |
| --- | --- |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
| --- | --- |

This International Searching Authority found multiple inventions in this international application, as follows:
    The matter common to the inventions in claims 1-10 is "a light reuse sheet comprising a reflection plane with a concavo-convex shape". However, this matter is not a special technical feature within the meaning of PCT Rule 13.2, second sentence since it is a well known and commonly used matter as disclosed in document JP 11-307791 A (Sanyo Electric Co., Ltd.), 05 November 1999 (05.11.1999), entire text, all drawings.
    Claims 1-6 relate to a light reuse sheet, wherein the reflection plane thereof satisfies [expression 1], while claims 7-10 relate to a solar battery module, wherein the distance C between the reflection plane thereof and the light-receiving plane of a solar battery cell    (Continued to the extra sheet.)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
1-6

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.

PCT/JP2009/006237

Continuation of Box No.III of continuation of first sheet(2)

satisfies [expression 2] and [expression 6]. Therefore, the present application does not comply with the unity of invention.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008295374 A
- JP 2009160853 A
- JP 2001295437 A

- JP H0461285 B
- JP H11274533 B
- JP H11307791 B